# EUROPEAN PATENT SPECIFICATION

(11) **EP 4 365 948 B1**
(45) Date of publication and mention of the grant of the patent: **04.03.2026**
(21) Application number: 22852855.0
(22) Date of filing: 21.07.2022
(51) Int. Cl.: H10D 1/64, H10D 30/47, H10D 64/20, H10D 84/00, H10D 84/01, H10D 84/05, H10D 84/02, H10D 84/80

(54) **VARIABLE CAPACITANCE ELEMENT**
ELEMENT MIT VARIABLER KAPAZITÄT
ÉLÉMENT À CAPACITÉ VARIABLE

(30) Priority: 03.08.2021 JP 2021127331
(43) Date of publication of application: 08.05.2024
(73) Proprietor: Nuvoton Technology Corporation Japan, Nagaokakyo City, Kyoto 617-8520 (JP)
(72) Inventor: NISHIO, Akihiko, Nagaokakyo City, Kyoto 617-8520 (JP); TAKAMI, Yoshinori, Uozu City, Toyama 937-8585 (JP)
(74) Representative: Novagraaf International SA
(86) International application number: PCT/JP2022/028355
(87) International publication number: WO 2023/013431

(56) References cited:
- JP-A- 2014 207 287
- US-A1- 2014 091 311
- US-A1- 2014 091 845
- US-A1- 2020 098 746
- US-A1- 2020 098 746

## Description

### [Technical Field]

The present disclosure relates to a variable capacitance element and, in particular, to a variable capacitance element including a semiconductor including a two-dimensional electron gas layer.

### [Background Art]

III-V semiconductors, especially arsenic semiconductors, such as GaAs and AlGaAs, and nitride semiconductors, such as GaN and AlGaN, can readily form, for example, an AlGaAs/GaAs heterostructure and an AlGaN/GaN heterostructure. For the III-V semiconductors, a high-mobility, high-concentration electron channel (two-dimensional electron gas (2DEG)) can be generated on the GaAs layer side of the AlGaAs/GaAs interface and on the GaN layer side of the AlGaN/GaN interface, by fixed electric charge due to spontaneous polarization caused by an ionic radius difference and piezoelectric polarization generated by a lattice constant difference between AlGaN and GaN, in addition to a band gap difference. A high-electron-mobility transistor (HEMT) can be made by controlling the two-dimensional electron gas channel. Because of their high-speed operation enabled by the high mobility of electrons, HEMTs are now widely used as high-frequency devices such as amplifiers and switching elements.

Recent years have seen an increase in use of integrated circuits (monolithic microwave integrated circuits (MMICs)) each including a resistance element and a capacitance element, as well as discrete products each using a single field effect transistor (EFT) or a single diode. In addition to a fixed capacitance element having a fixed capacitance value, a variable capacitance element that controls capacitance in a certain range is used as a capacitance element used in an MMIC. As described in Patent Literature (PTL) 1, benefits in terms of manufacturing costs and the controllability of a matching circuit are brought by forming a variable capacitance element on a chip including a HEMT using a two-dimensional electron gas layer.

### [Citation List]

### [Patent Literature]

[PTL 1] Japanese Unexamined Patent Application Publication No. 9-331025

### [Summary of Invention]

### [Technical Problem]

In a variable capacitance element formed on a chip including a HEMT, it is desirable that a capacitance value should significantly change with respect to an applied voltage and the change should be a linear change with respect to the applied voltage. A varactor diode is used in the conventional technology described in PTL 1. As an existing problem, since the capacitance control range has a narrow range in which capacitance linearly changes with respect to an applied voltage, the oscillatory frequency modulation range of an oscillator is narrow, which results in a failure to obtain a semiconductor device having desired characteristics. Furthermore, as an existing problem, the capacitance value is changed due to addition of a signal amplitude to a capacitance control voltage.

In view of the above, the present disclosure provides a variable capacitance element in which a capacitance value significantly changes with respect to an applied voltage, the change is a linear change with respect to the voltage, and even with addition of an amplitude signal to a capacitance control voltage, the capacitance value can be controlled to be within a predetermined range.

### [Solution to Problem]

A variable capacitance element according to the present disclosure includes: a substrate; a first semiconductor layer provided above the substrate; a dielectric layer provided above the first semiconductor layer and including a second semiconductor layer having a band gap larger than the band gap of the first semiconductor layer; a two-dimensional electron gas layer provided at the interface between the first semiconductor layer and the second semiconductor layer; a first electrode provided above the dielectric layer and including a first terminal; and a second terminal spaced apart from the first electrode in a plan view of the substrate and electrically connected to the two-dimensional electron gas layer. The two-dimensional electron gas layer below the first electrode functions as a second electrode, the interval between the bottom surface of the first electrode and the top surface of the first semiconductor layer monotonically increases in a first direction or in a second direction, the first direction being the direction from the first electrode toward the second terminal, the second direction being orthogonal to the first direction in the plan view of the substrate, and the capacitance value between the first electrode and the second electrode changes according to the voltage applied between the first electrode and the second terminal.

### [Advantageous Effects of Invention]

The present disclosure provides a variable capacitance element in which a capacitance value significantly changes with respect to an applied voltage, the change is a linear change with respect to the voltage, and even with addition of an amplitude signal to a capacitance control voltage, the capacitance value can be controlled to be within a predetermined range.

### [Brief Description of Drawings]

[FIG. 1]

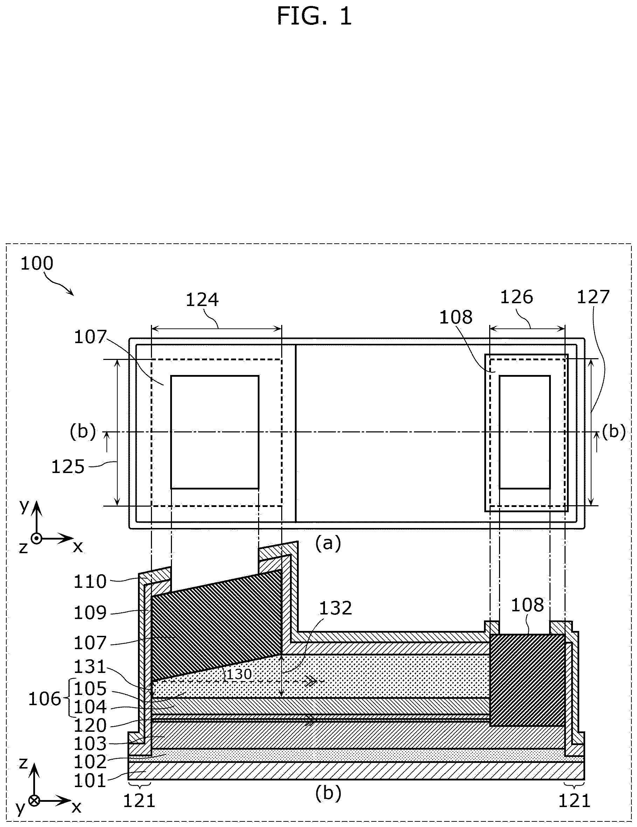

   FIG. 1 includes a plan view and a cross-sectional view that illustrate a configuration of a variable capacitance element according to Embodiment 1.
[FIG. 2]

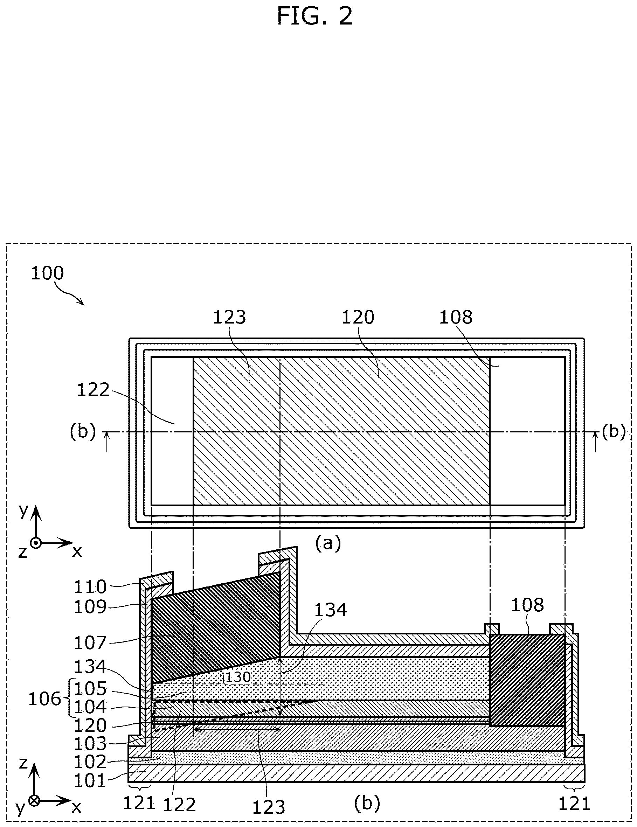

   FIG. 2 includes a plan view and a cross-sectional view that illustrate a state of the variable capacitance element according to Embodiment 1 when a voltage is applied.
[FIG. 3]

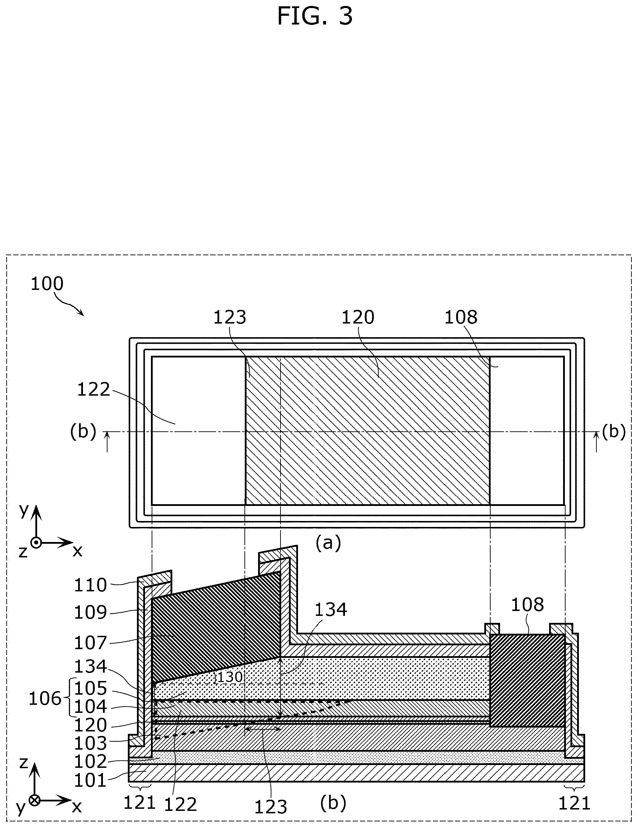

   FIG. 3 includes a plan view and a cross-sectional view that illustrate a state of the variable capacitance element according to Embodiment 1 when a voltage is applied.
[FIG. 4]

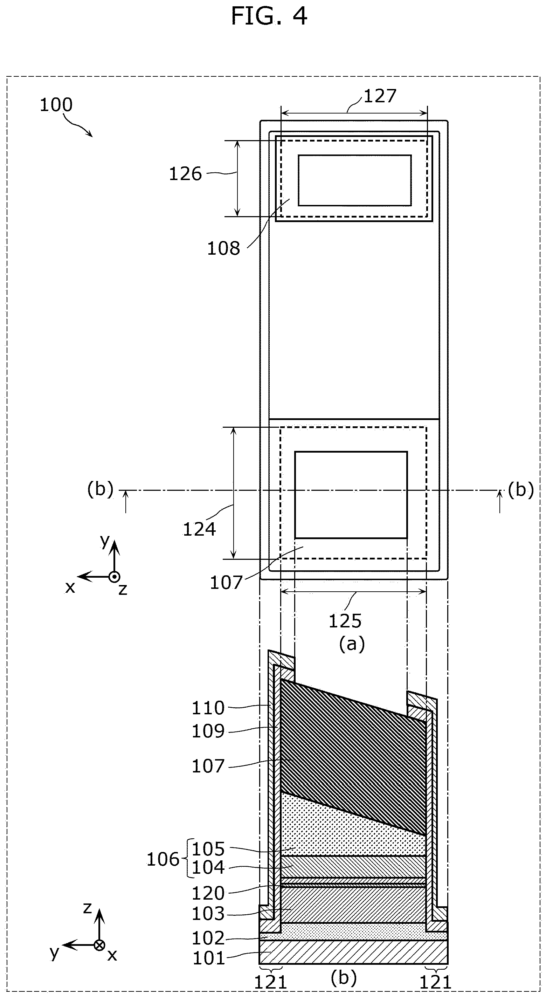

   FIG. 4 includes a plan view and a cross-sectional view that illustrate a configuration of a variable capacitance element in another example according to Embodiment 1.
[FIG. 5]

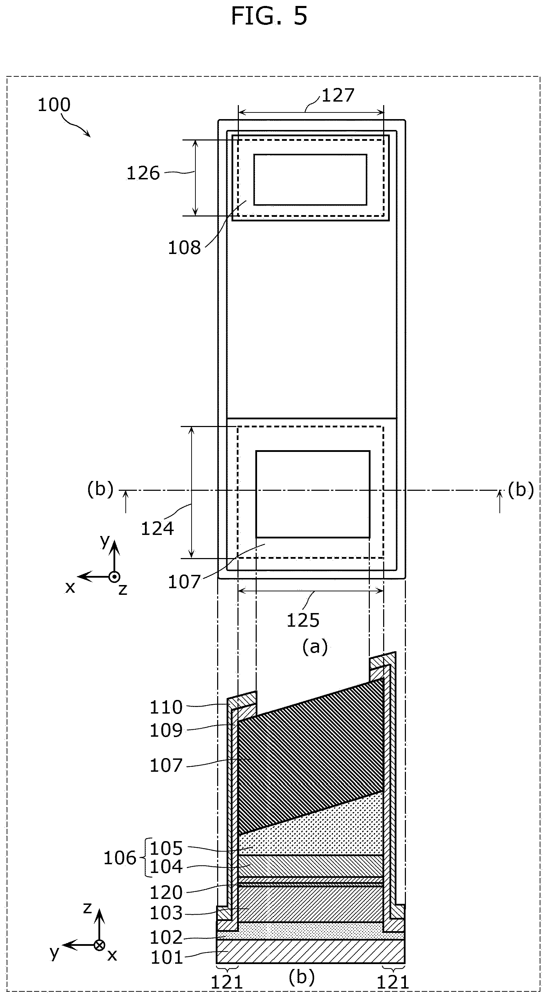

   FIG. 5 includes a plan view and a cross-sectional view that illustrate a configuration of a variable capacitance element in another example according to Embodiment 1.
[FIG. 6]

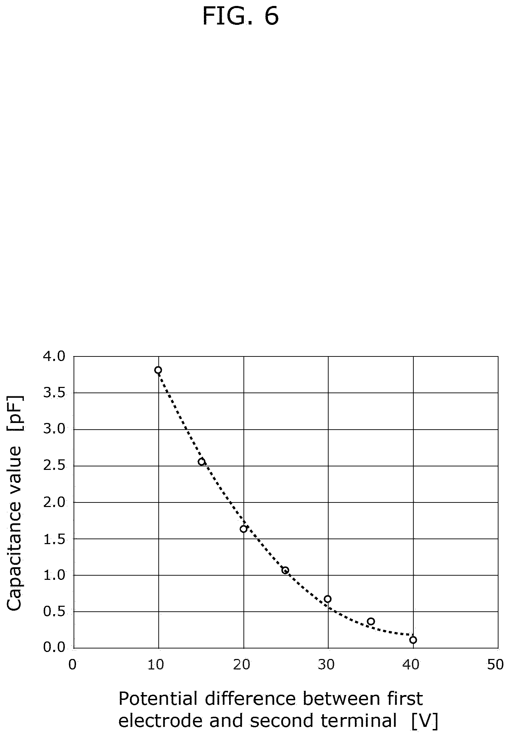

   FIG. 6 is a graph illustrating a change in the capacitance value with respect to the potential difference between the first electrode and the second terminal of the variable capacitance element according to Embodiment 1.
[FIG. 7]

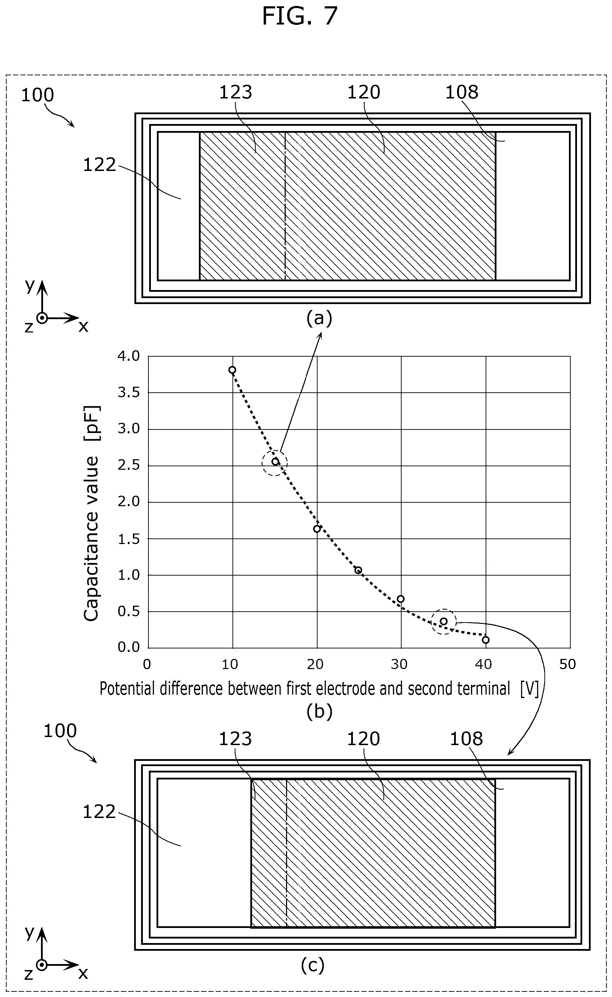

   FIG. 7 is a figure to compare a graph and plan views, the graph illustrating a change in the capacitance value with respect to the potential difference between the first electrode and the second terminal of the variable capacitance element according to Embodiment 1, the plan views illustrating states when a voltage is applied.
[FIG. 8]

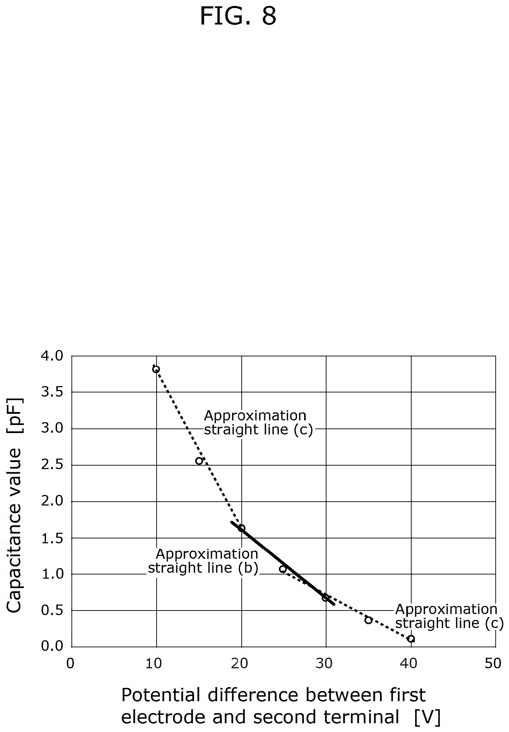

   FIG. 8 is a graph illustrating a change in the capacitance value with respect to the potential difference between the first electrode and the second terminal of the variable capacitance element according to Embodiment 1.
[FIG. 9]

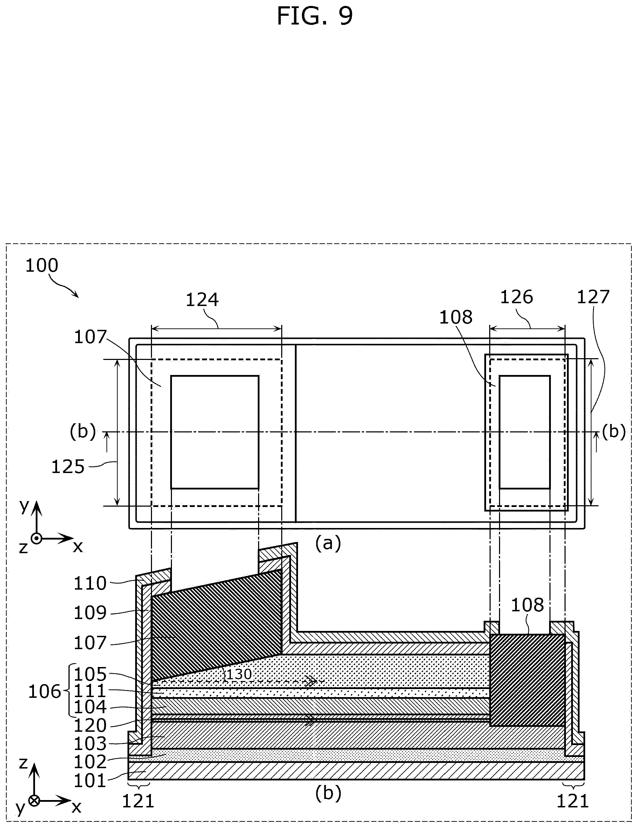

   FIG. 9 includes a plan view and a cross-sectional view that illustrate a configuration of a variable capacitance element in another example according to Embodiment 1.
[FIG. 10]

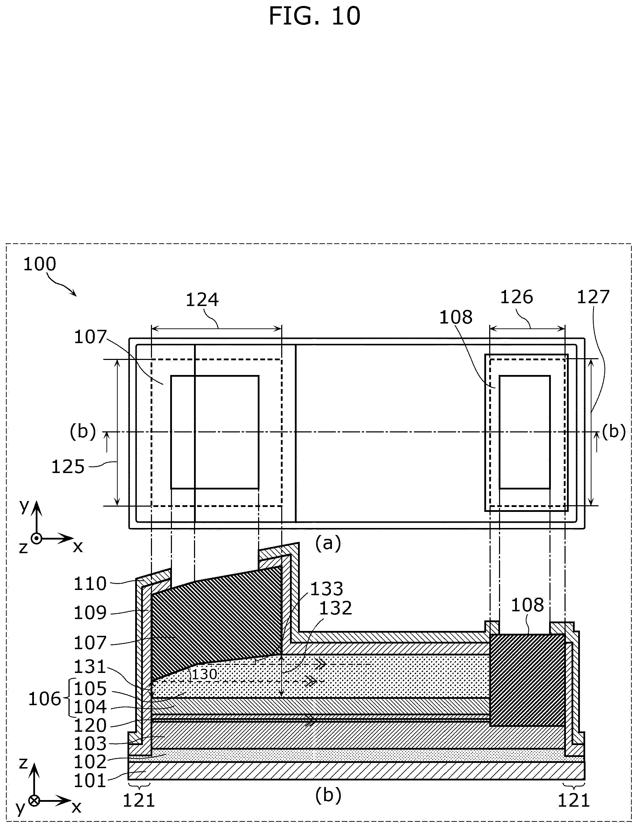

   FIG. 10 includes a plan view and a cross-sectional view that illustrate a configuration of a variable capacitance element in another example according to Embodiment 1.
[FIG. 11]

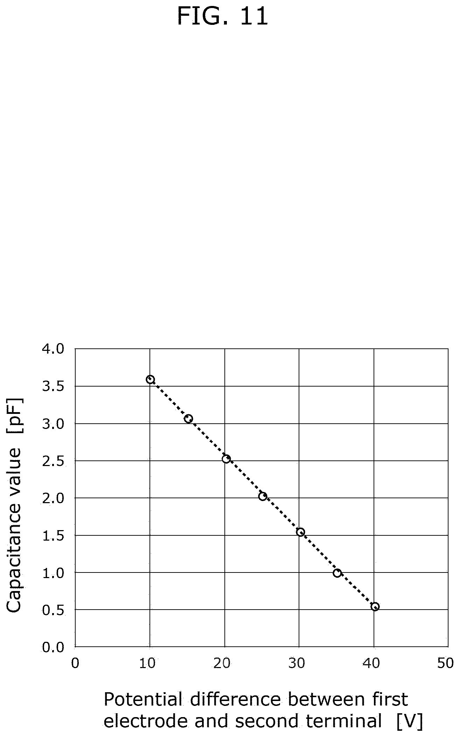

   FIG. 11 is a graph illustrating a change in the capacitance value with respect to the potential difference between the first electrode and the second terminal of the variable capacitance element in the example in FIG. 10 according to Embodiment 1.
[FIG. 12]

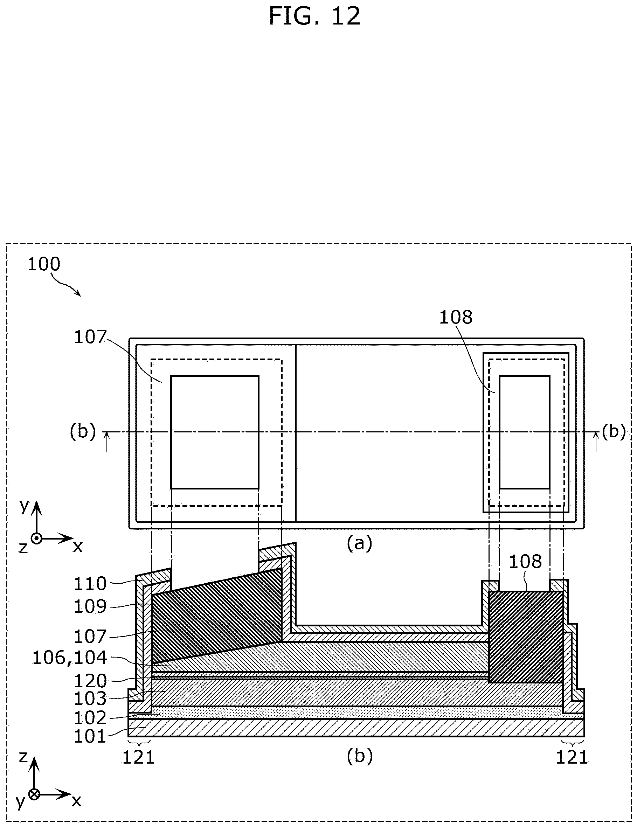

   FIG. 12 includes a plan view and a cross-sectional view that illustrate a configuration of a variable capacitance element in another example according to Embodiment 1.
[FIG. 13]

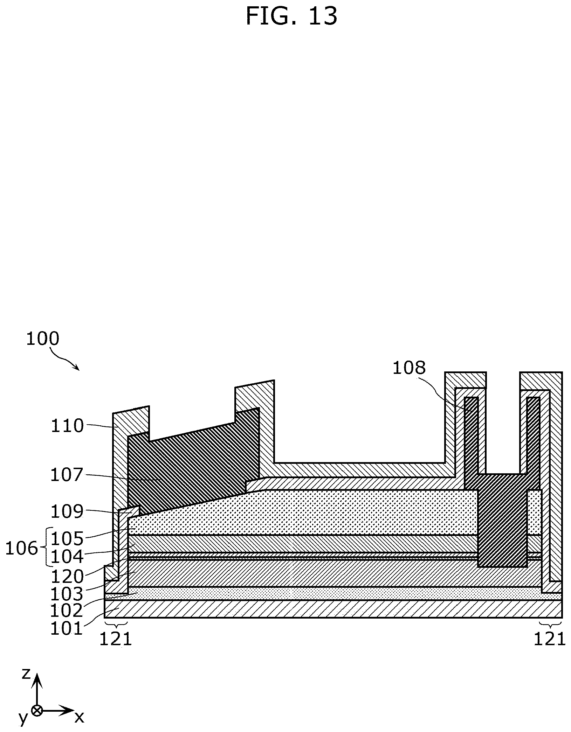

   FIG. 13 is a cross-sectional view illustrating a configuration of a variable capacitance element in another example according to Embodiment 1.
[FIG. 14]

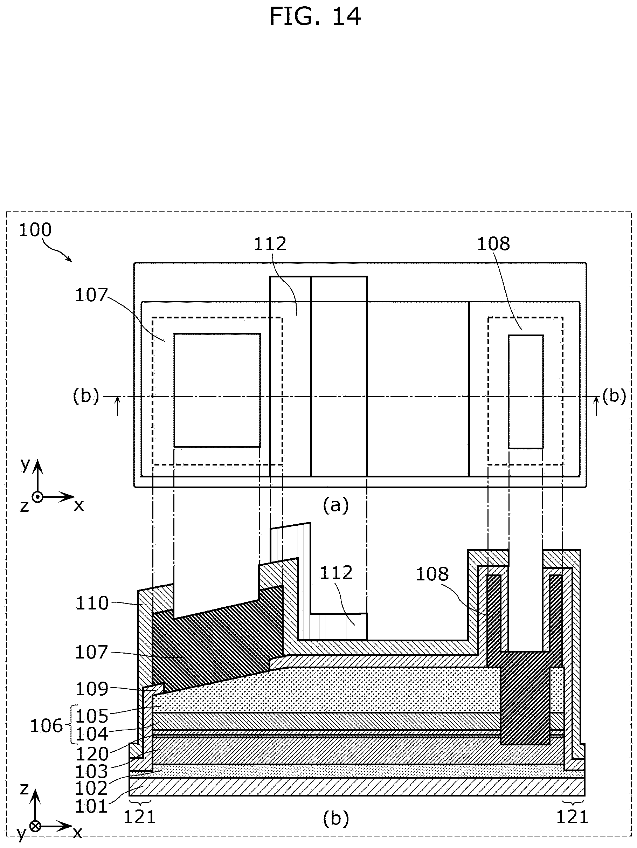

   FIG. 14 includes a plan view and a cross-sectional view that illustrate a configuration of a variable capacitance element in another example according to Embodiment 1.
[FIG. 15]

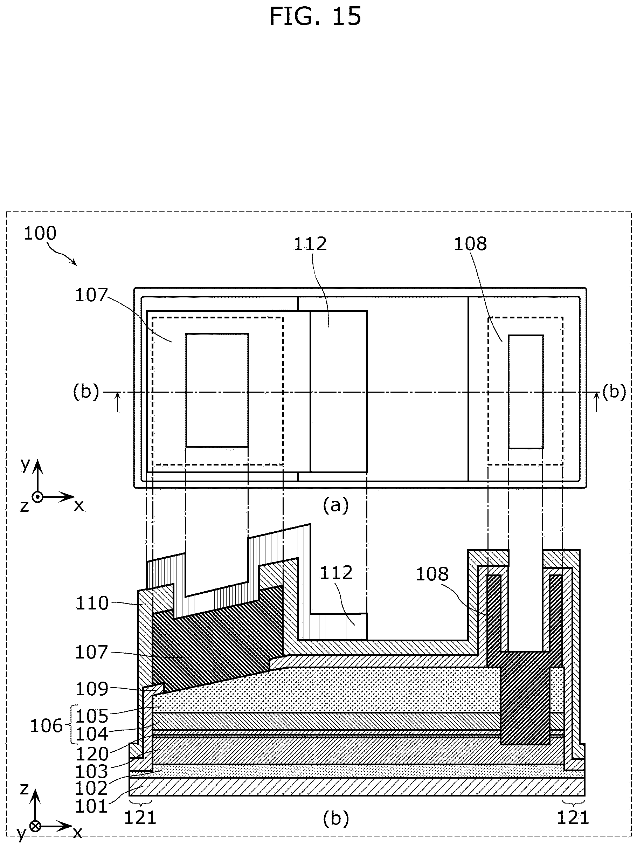

   FIG. 15 includes a plan view and a cross-sectional view that illustrate a configuration of a variable capacitance element in another example according to Embodiment 1.
[FIG. 16]

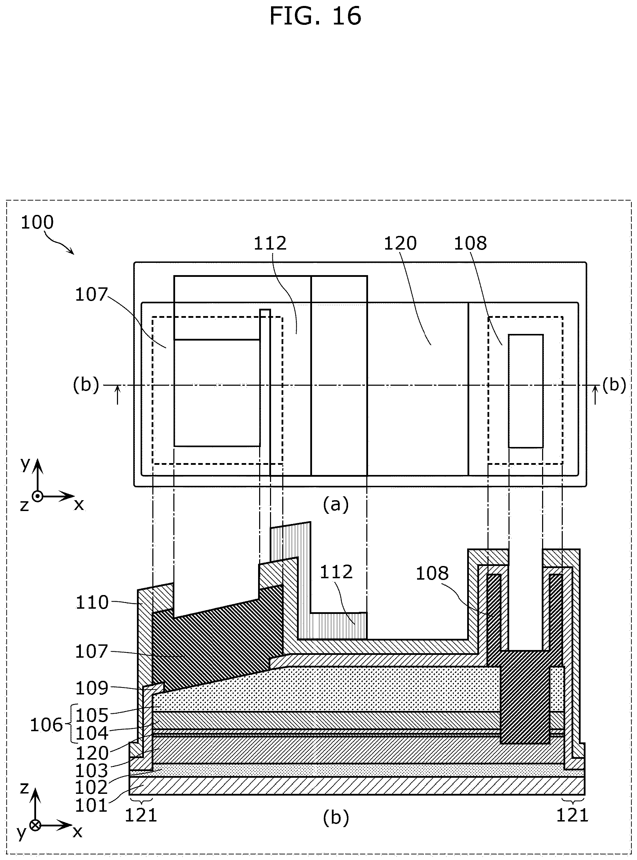

   FIG. 16 includes a plan view and a cross-sectional view that illustrate a configuration of a variable capacitance element in another example according to Embodiment 1.
[FIG. 17]

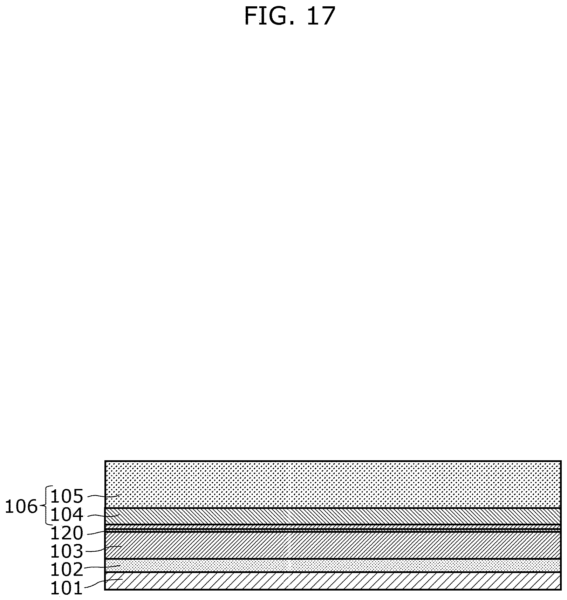

   FIG. 17 is a cross-sectional view illustrating a structure of a variable capacitance element according to Embodiment 1 during a manufacturing process.
[FIG. 18]

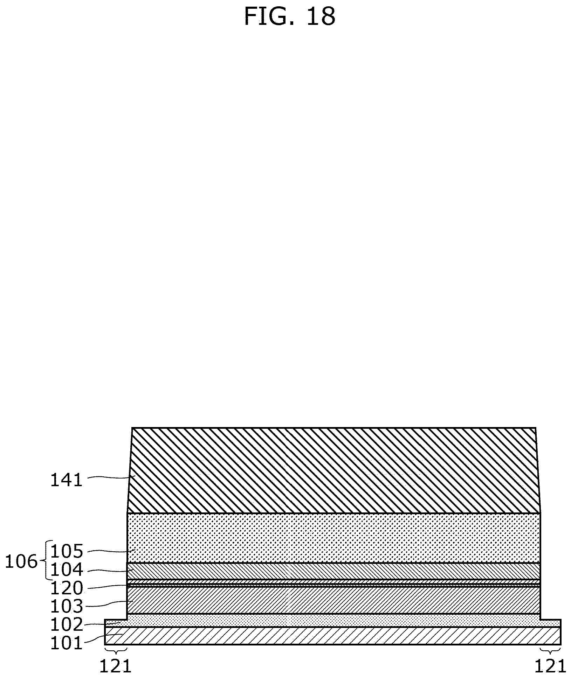

   FIG. 18 is a cross-sectional view illustrating a structure of the variable capacitance element according to Embodiment 1 during the manufacturing process.
[FIG. 19]

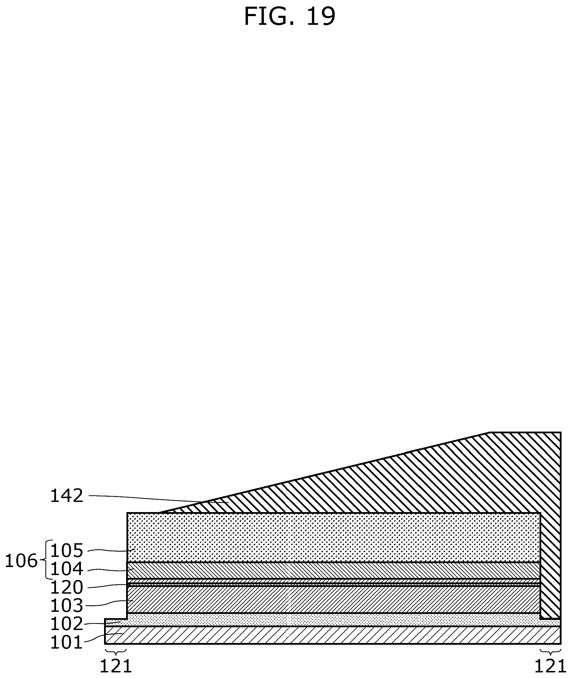

   FIG. 19 is a cross-sectional view illustrating a structure of the variable capacitance element according to Embodiment 1 during the manufacturing process.
[FIG. 20]

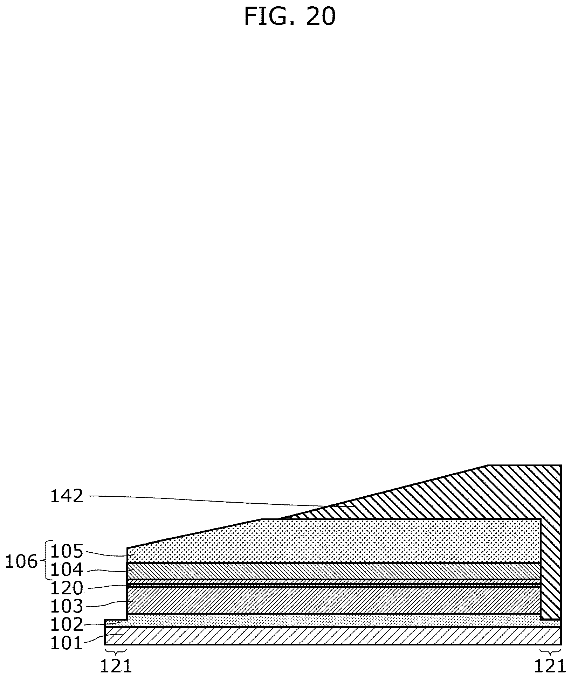

   FIG. 20 is a cross-sectional view illustrating a structure of the variable capacitance element according to Embodiment 1 during the manufacturing process.
[FIG. 21]

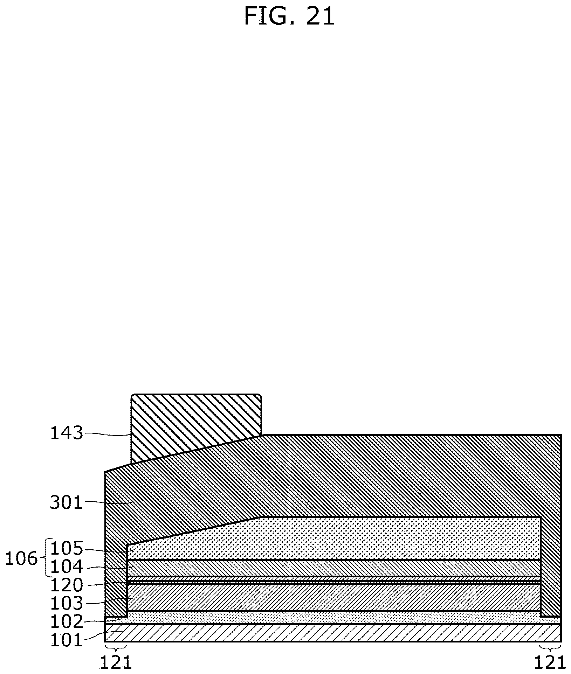

   FIG. 21 is a cross-sectional view illustrating a structure of the variable capacitance element according to Embodiment 1 during the manufacturing process.
[FIG. 22]

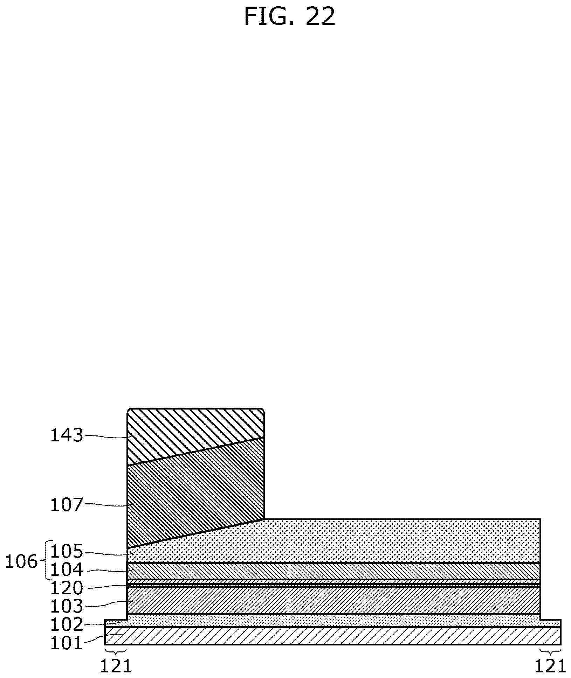

   FIG. 22 is a cross-sectional view illustrating a structure of the variable capacitance element according to Embodiment 1 during the manufacturing process.
[FIG. 23]

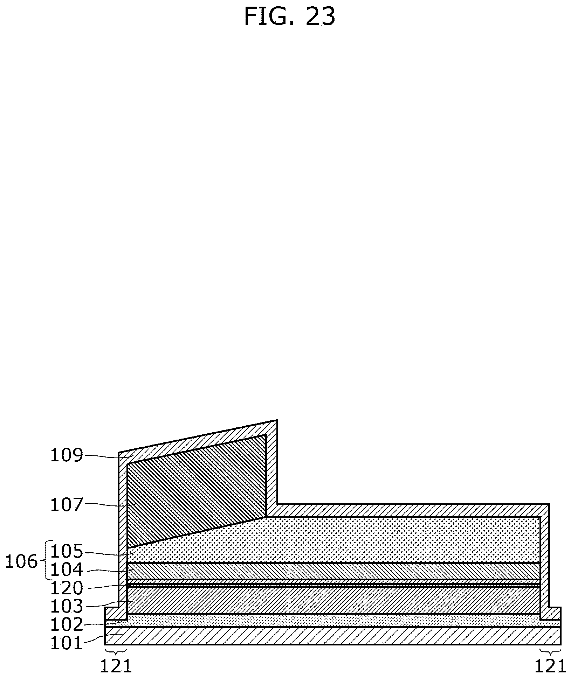

   FIG. 23 is a cross-sectional view illustrating a structure of the variable capacitance element according to Embodiment 1 during the manufacturing process.
[FIG. 24]

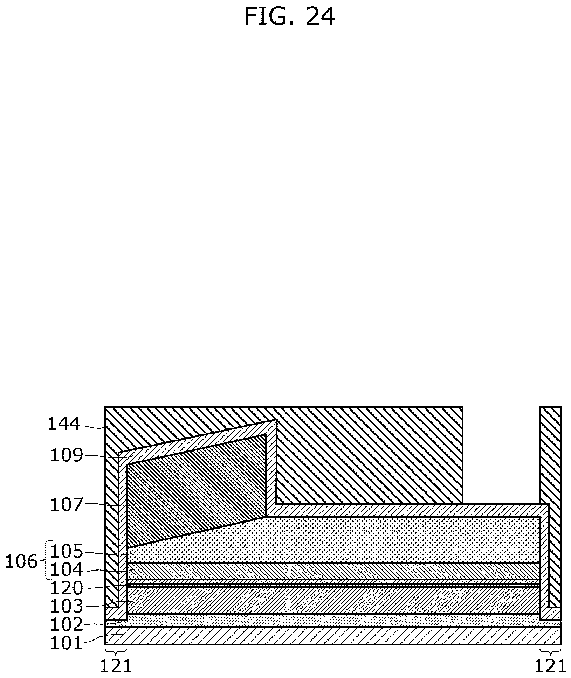

   FIG. 24 is a cross-sectional view illustrating a structure of the variable capacitance element according to Embodiment 1 during the manufacturing process.
[FIG. 25]

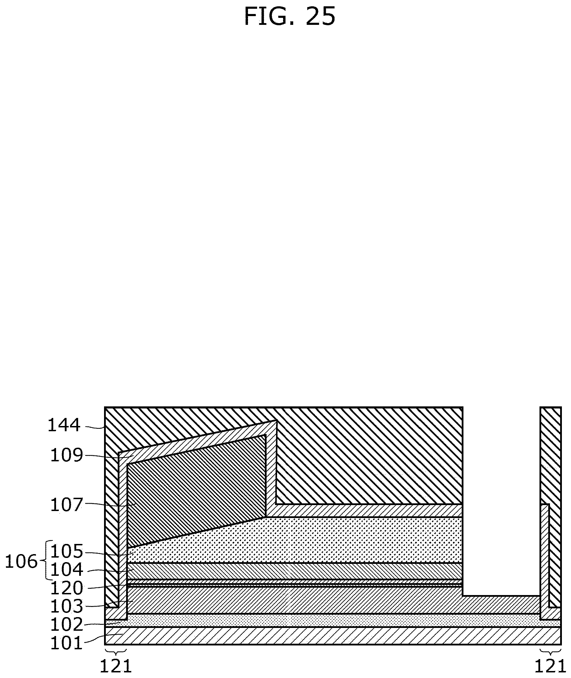

   FIG. 25 is a cross-sectional view illustrating a structure of the variable capacitance element according to Embodiment 1 during the manufacturing process.
[FIG. 26]

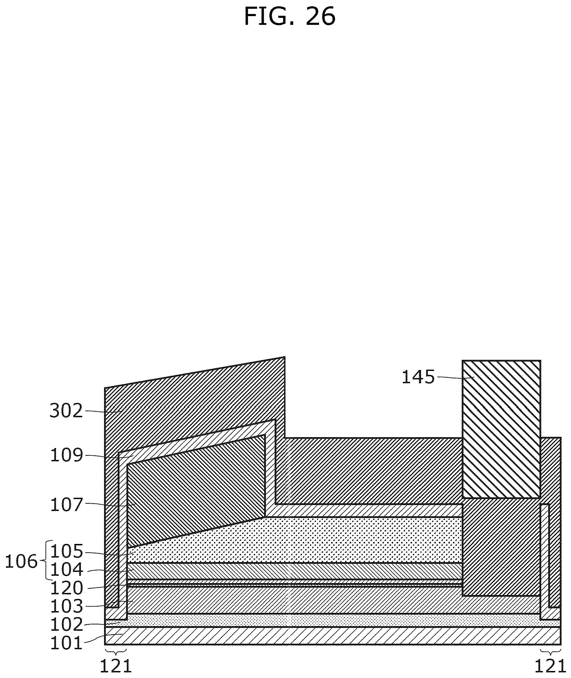

   FIG. 26 is a cross-sectional view illustrating a structure of the variable capacitance element according to Embodiment 1 during the manufacturing process.
[FIG. 27]

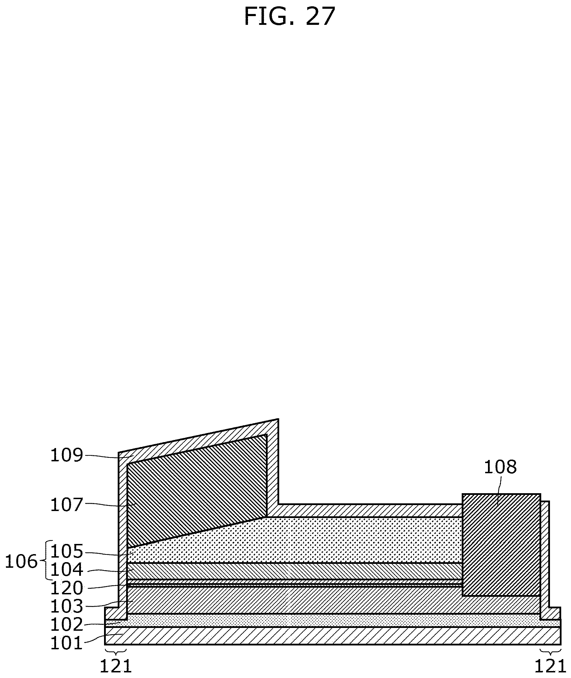

   FIG. 27 is a cross-sectional view illustrating a structure of the variable capacitance element according to Embodiment 1 during the manufacturing process.
[FIG. 28]

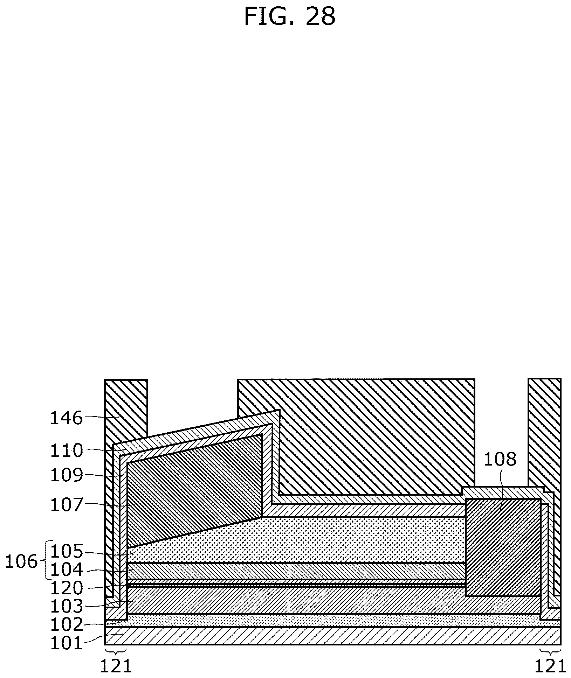

   FIG. 28 is a cross-sectional view illustrating a structure of the variable capacitance element according to Embodiment 1 during the manufacturing process.
[FIG. 29]

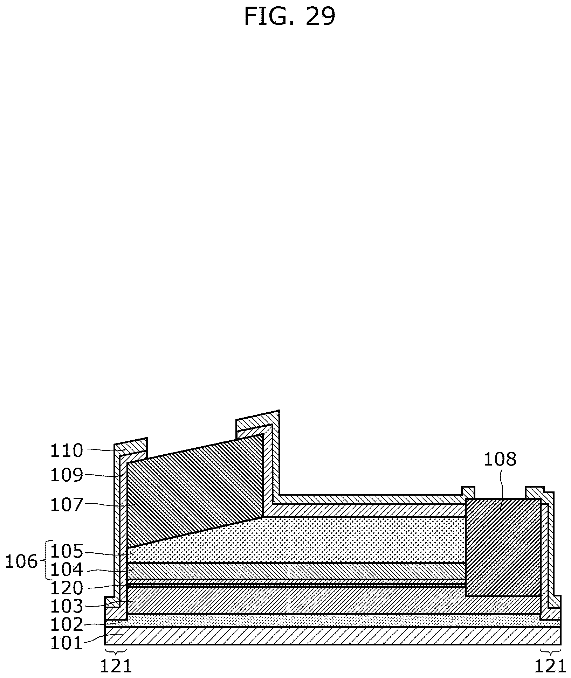

   FIG. 29 is a cross-sectional view illustrating a structure of the variable capacitance element according to Embodiment 1 during the manufacturing process.
[FIG. 30]

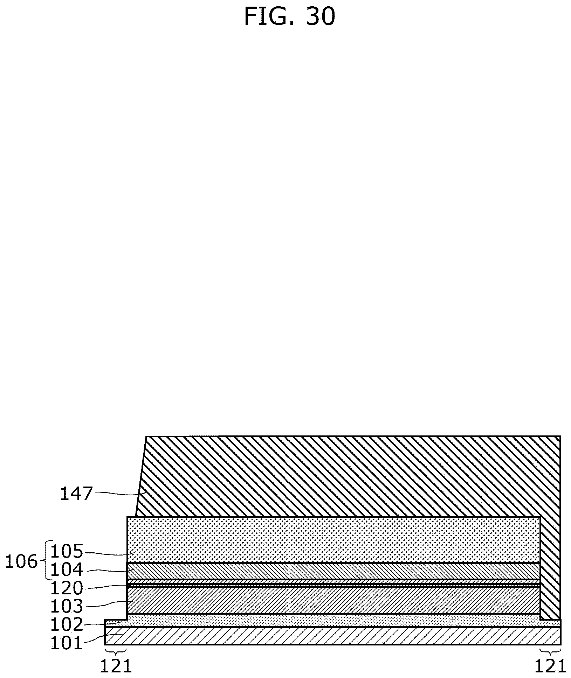

   FIG. 30 is a cross-sectional view illustrating a structure of the variable capacitance element according to Embodiment 1 during another manufacturing process.
[FIG. 31]

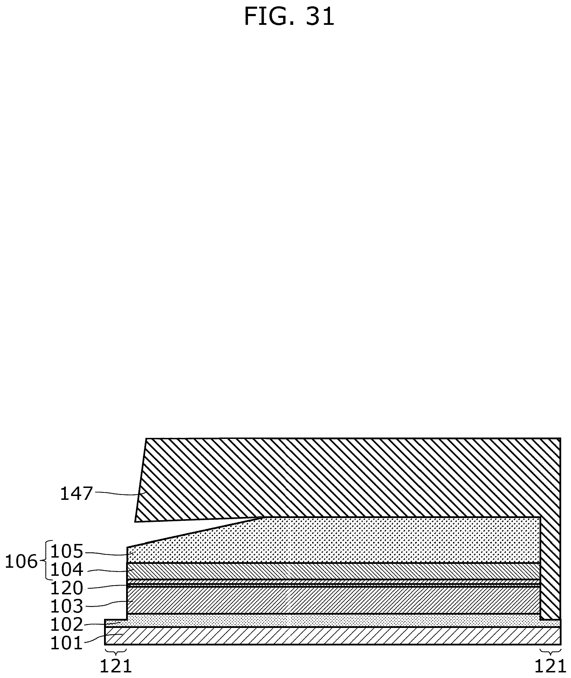

   FIG. 31 is a cross-sectional view illustrating a structure of the variable capacitance element according to Embodiment 1 during the manufacturing process.
[FIG. 32]

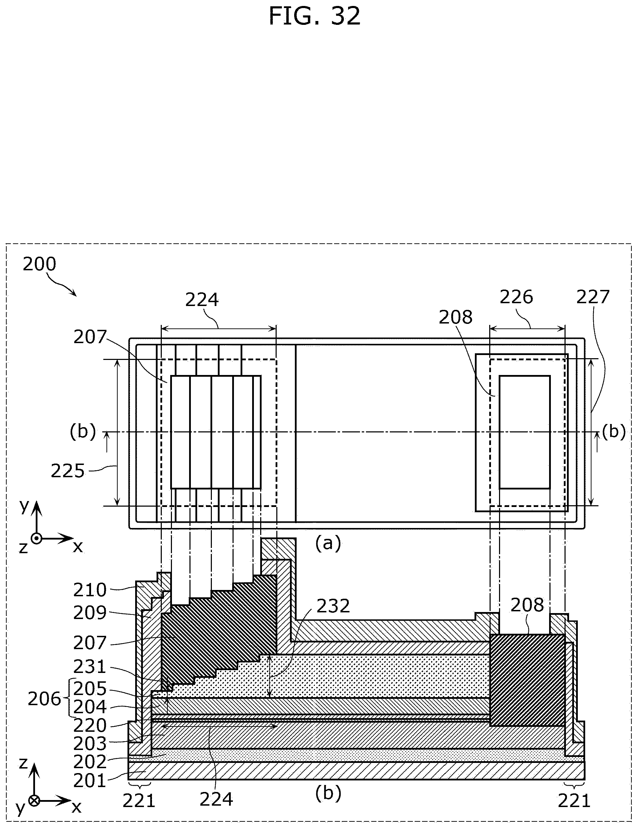

   FIG. 32 includes a plan view and a cross-sectional view that illustrate a configuration of a variable capacitance element according to Embodiment 2.
[FIG. 33]

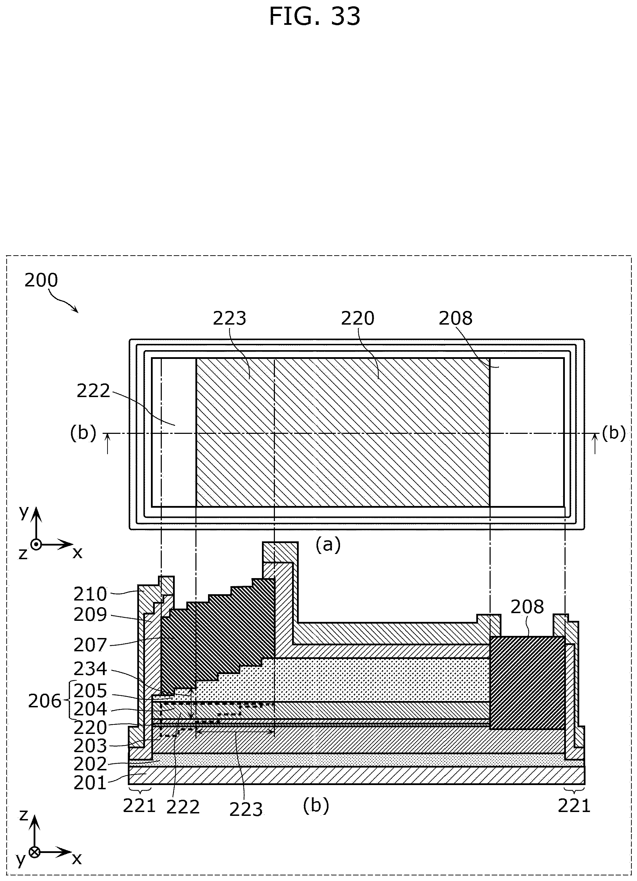

   FIG. 33 includes a plan view and a cross-sectional view that illustrate a state of the variable capacitance element according to Embodiment 2 when a voltage is applied.
[FIG. 34]

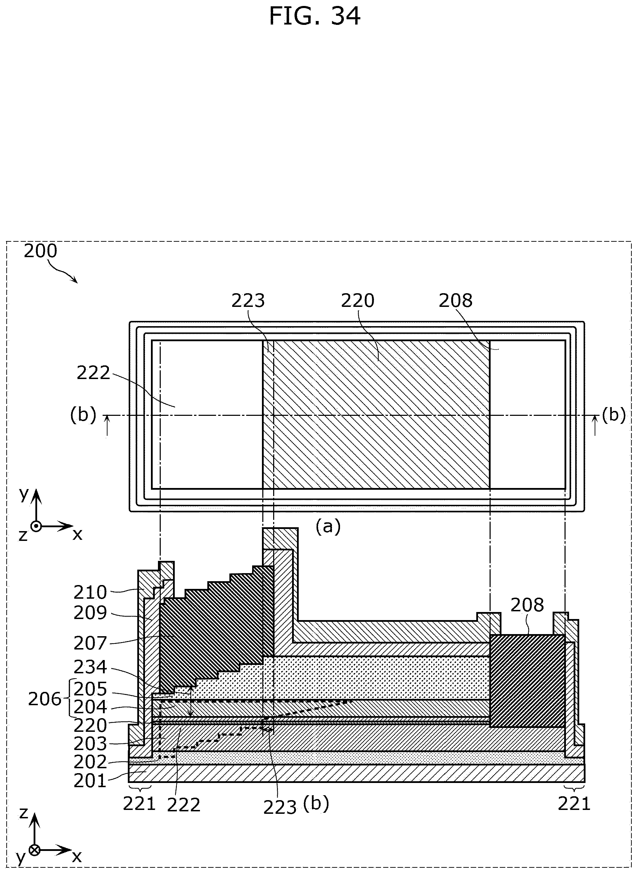

   FIG. 34 includes a plan view and a cross-sectional view that illustrate a state of the variable capacitance element according to Embodiment 2 when a voltage is applied.
[FIG. 35]

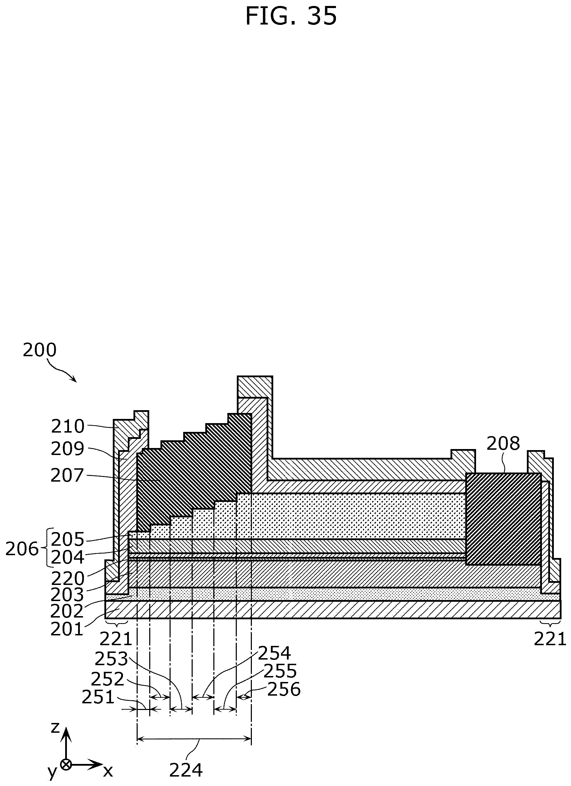

   FIG. 35 is a cross-sectional view illustrating a detailed configuration of the variable capacitance element according to Embodiment 2.
[FIG. 36]

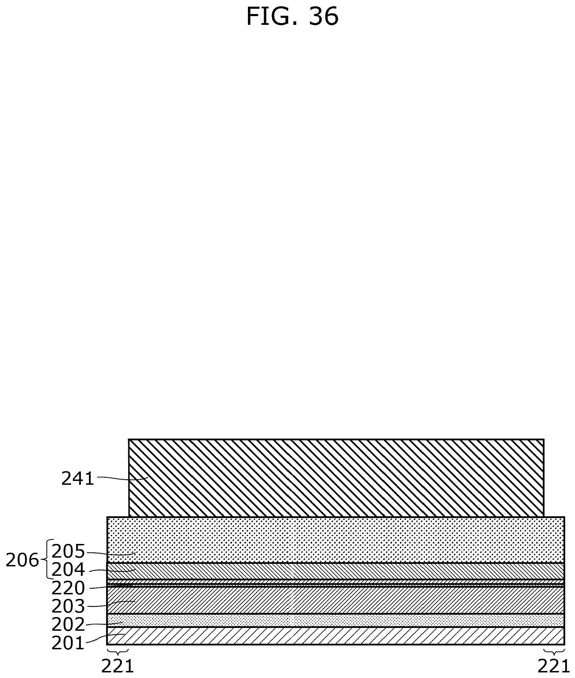

   FIG. 36 is a cross-sectional view illustrating a structure of the variable capacitance element according to Embodiment 2 during a manufacturing process.
[FIG. 37]

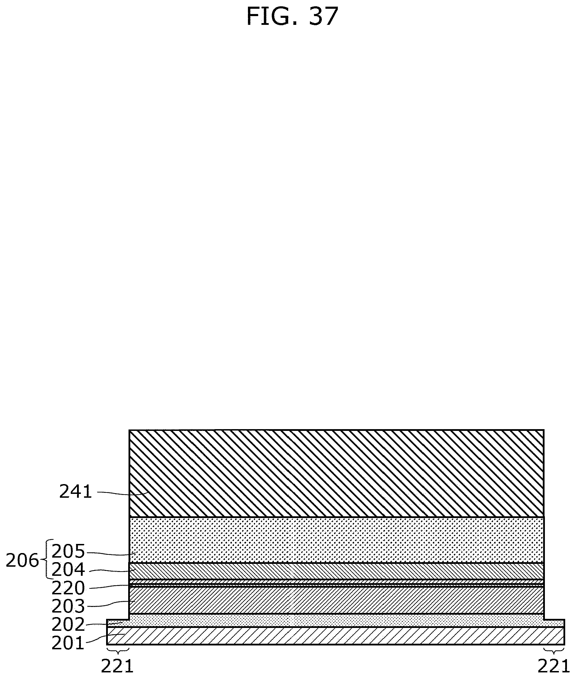

   FIG. 37 is a cross-sectional view illustrating a structure of the variable capacitance element according to Embodiment 2 during the manufacturing process.
[FIG. 38]

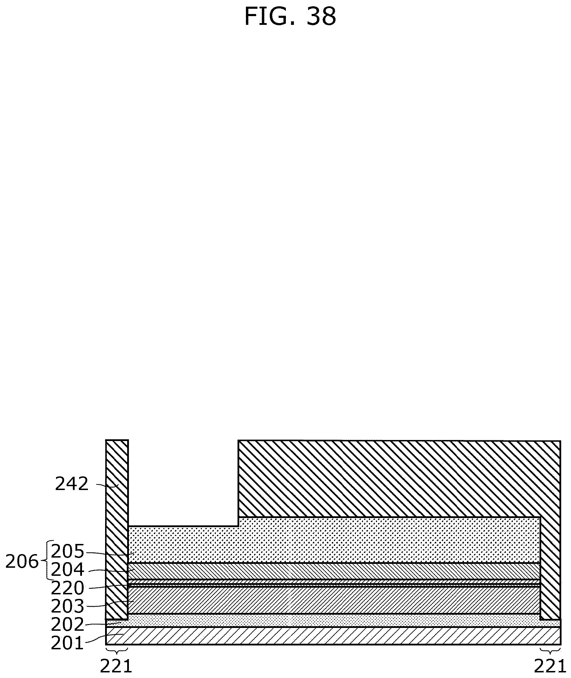

   FIG. 38 is a cross-sectional view illustrating a structure of the variable capacitance element according to Embodiment 2 during the manufacturing process.
[FIG. 39]

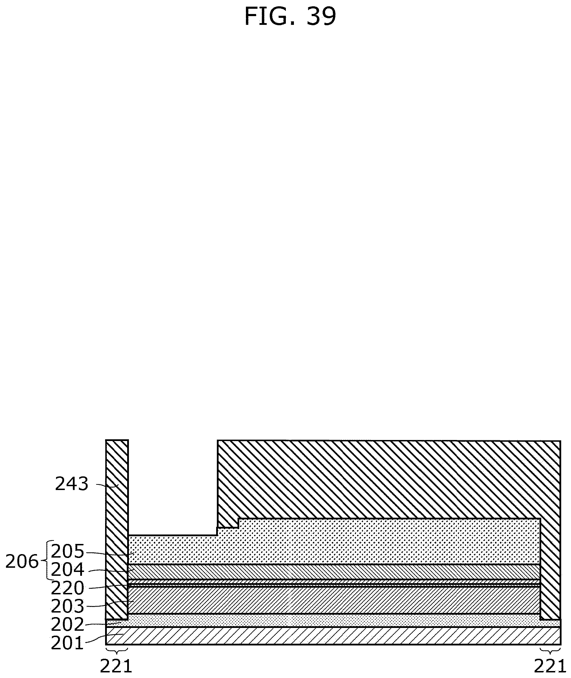

   FIG. 39 is a cross-sectional view illustrating a structure of the variable capacitance element according to Embodiment 2 during the manufacturing process.
[FIG. 40]

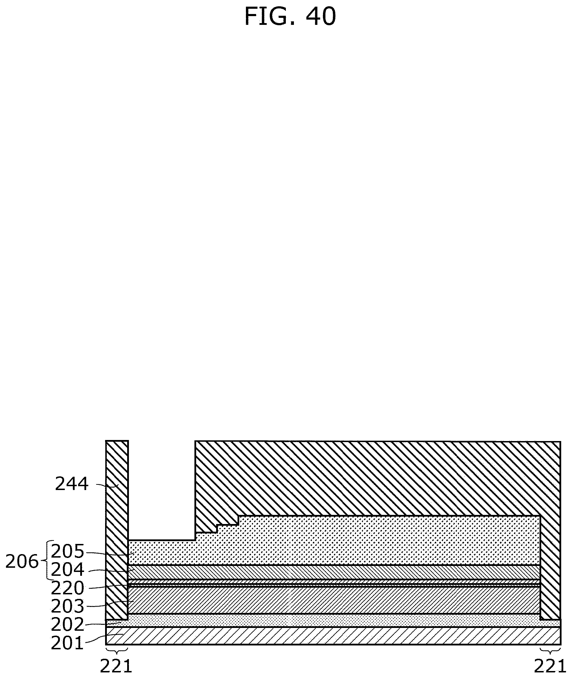

   FIG. 40 is a cross-sectional view illustrating a structure of the variable capacitance element according to Embodiment 2 during the manufacturing process.
[FIG. 41]

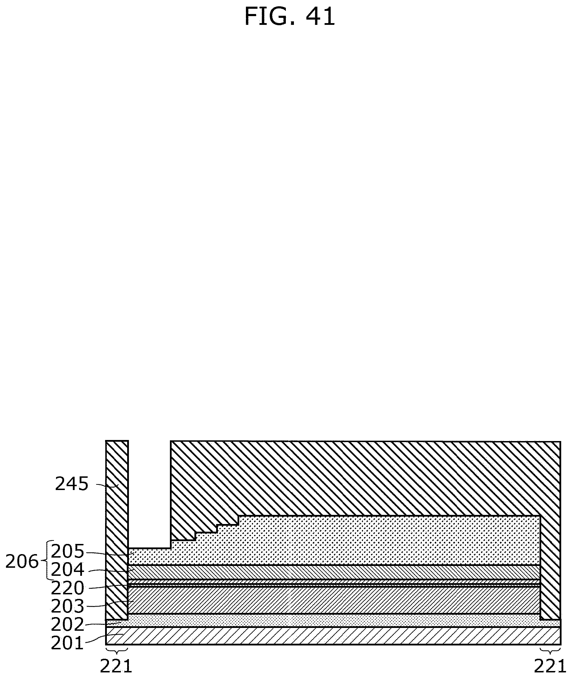

   FIG. 41 is a cross-sectional view illustrating a structure of the variable capacitance element according to Embodiment 2 during the manufacturing process.
[FIG. 42]

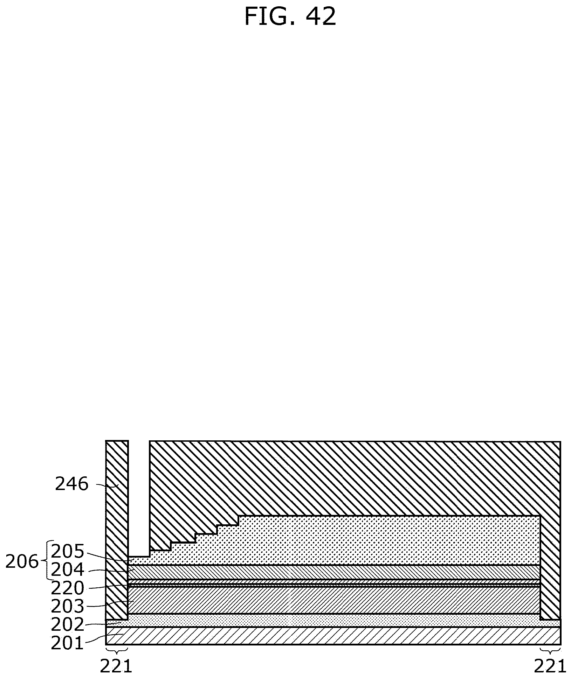

   FIG. 42 is a cross-sectional view illustrating a structure of the variable capacitance element according to Embodiment 2 during the manufacturing process.
[FIG. 43]

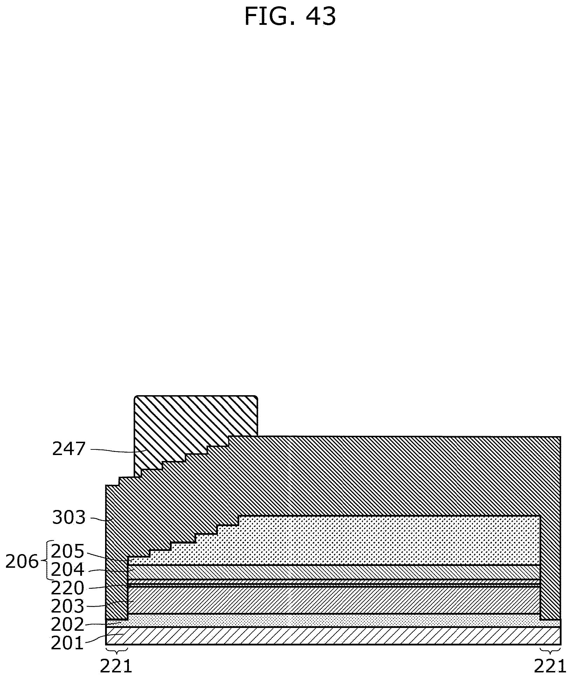

   FIG. 43 is a cross-sectional view illustrating a structure of the variable capacitance element according to Embodiment 2 during the manufacturing process.
[FIG. 44]

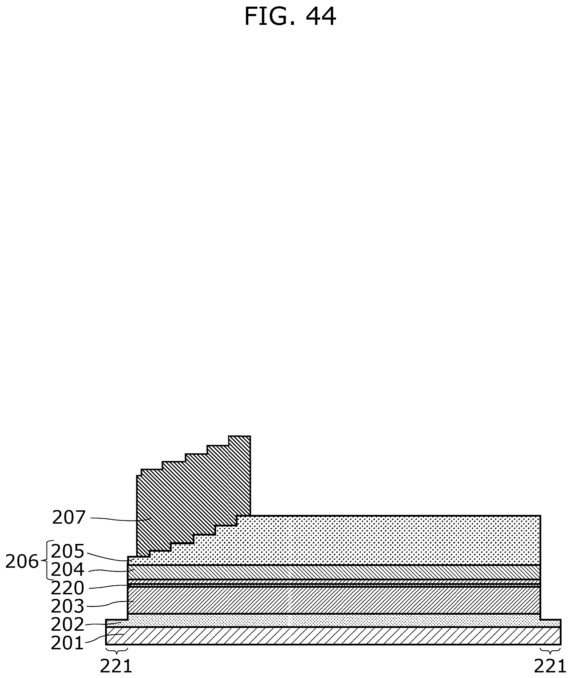

   FIG. 44 is a cross-sectional view illustrating a structure of the variable capacitance element according to Embodiment 2 during the manufacturing process.
[FIG. 45]

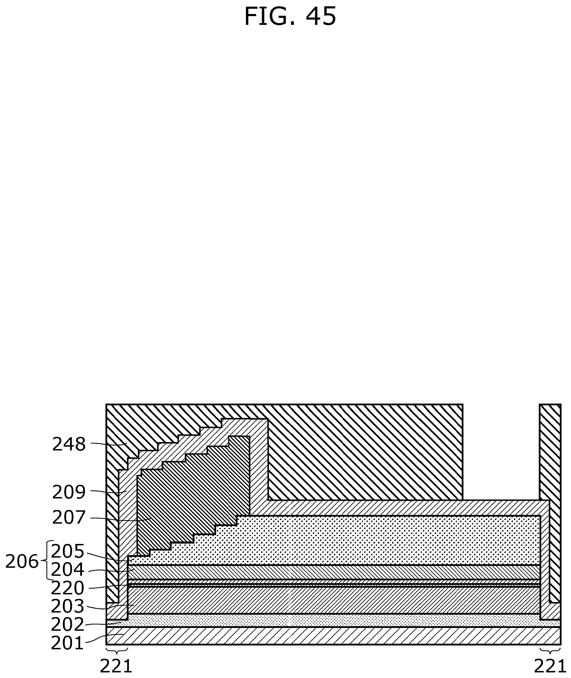

   FIG. 45 is a cross-sectional view illustrating a structure of the variable capacitance element according to Embodiment 2 during the manufacturing process.
[FIG. 46]

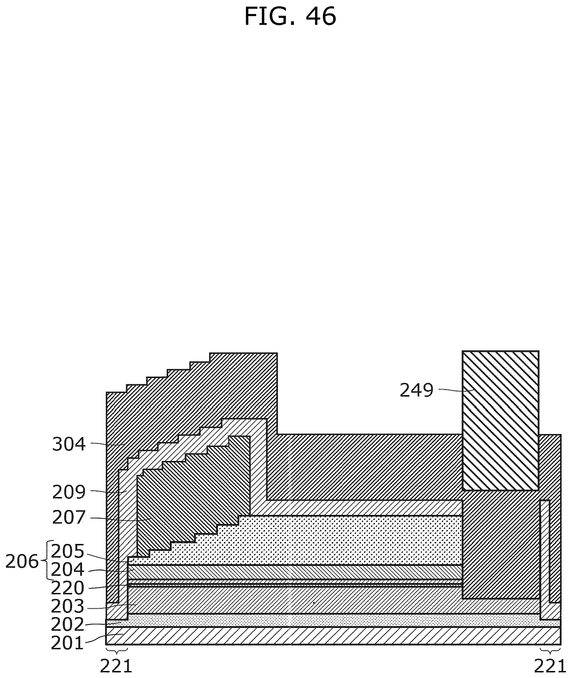

   FIG. 46 is a cross-sectional view illustrating a structure of the variable capacitance element according to Embodiment 2 during the manufacturing process.
[FIG. 47]

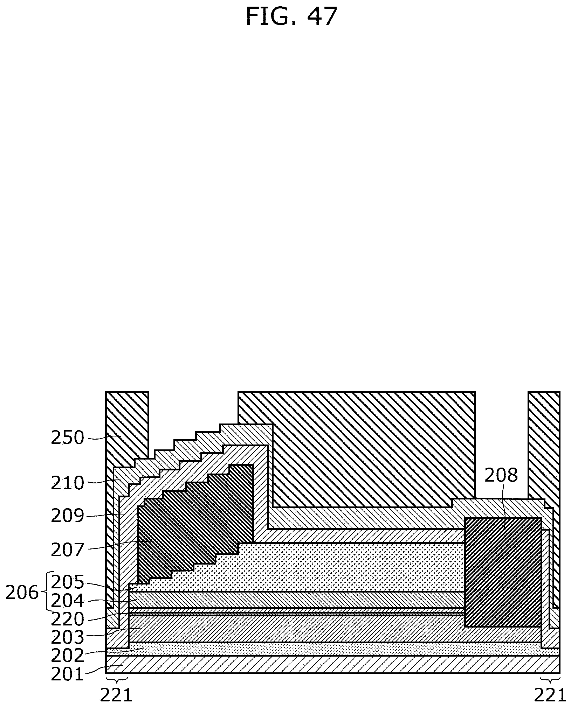

   FIG. 47 is a cross-sectional view illustrating a structure of the variable capacitance element according to Embodiment 2 during the manufacturing process.
[FIG. 48]

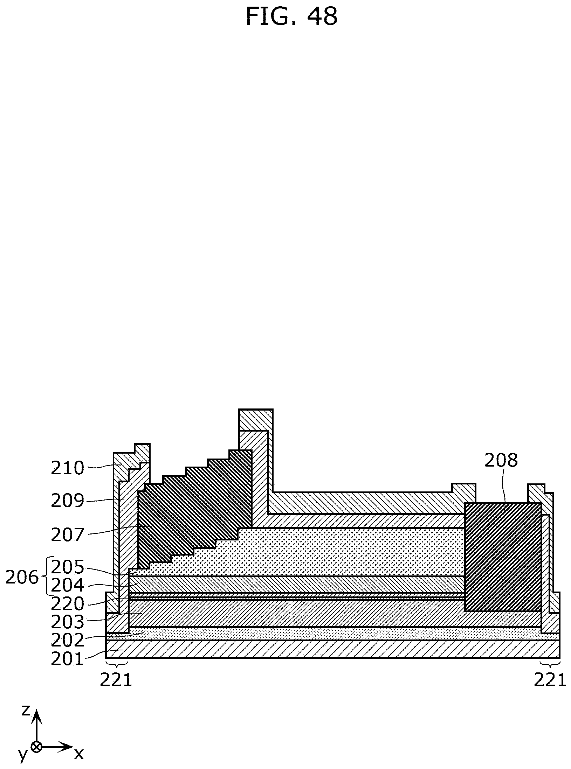

   FIG. 48 is a cross-sectional view illustrating a structure of the variable capacitance element according to Embodiment 2 during the manufacturing process.
[FIG. 49]

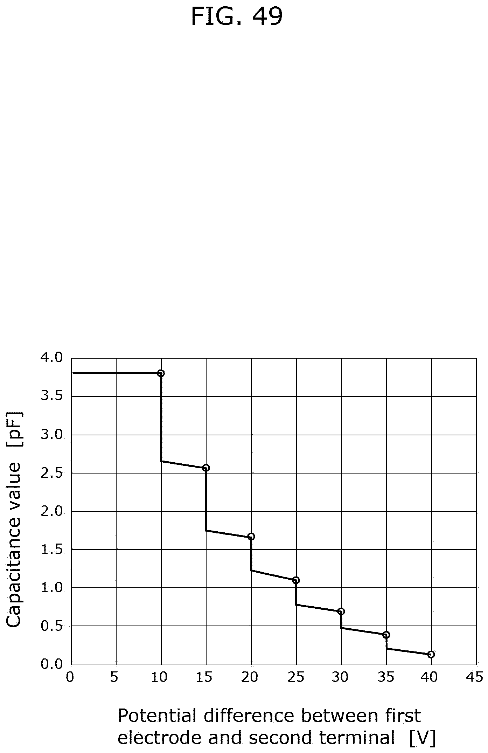

   FIG. 49 is a graph illustrating a change in the capacitance value with respect to the potential difference between the first electrode and the second terminal of the variable capacitance element according to Embodiment 2.
[FIG. 50]

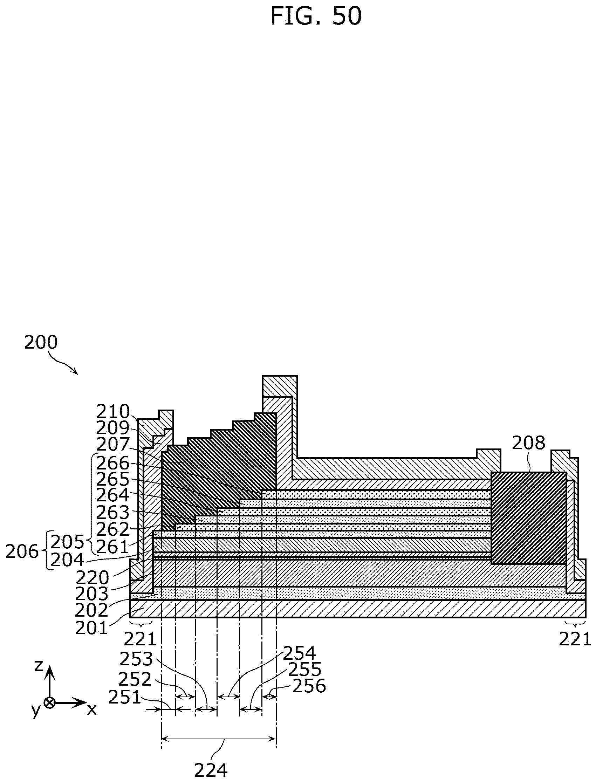

   FIG. 50 is a cross-sectional view illustrating a configuration of a variable capacitance element in another example according to Embodiment 2.
[FIG. 51]

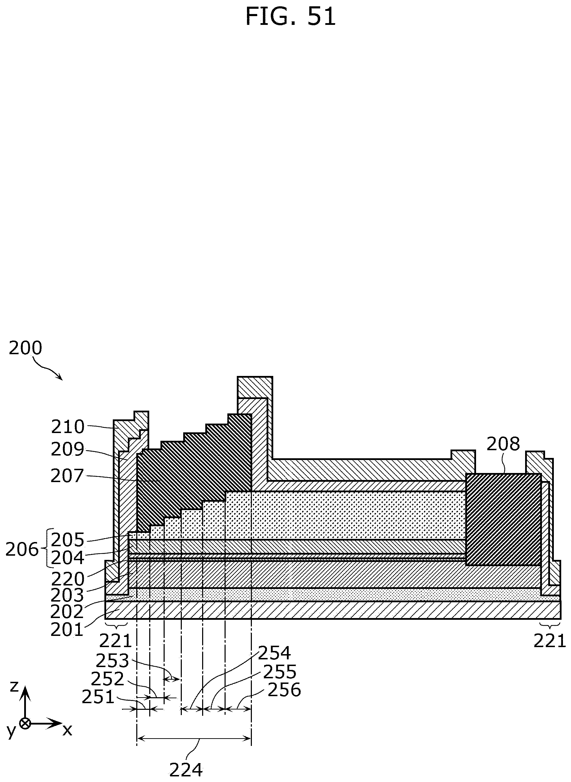

   FIG. 51 is a cross-sectional view illustrating a configuration of a variable capacitance element in another example according to Embodiment 2.
[FIG. 52]

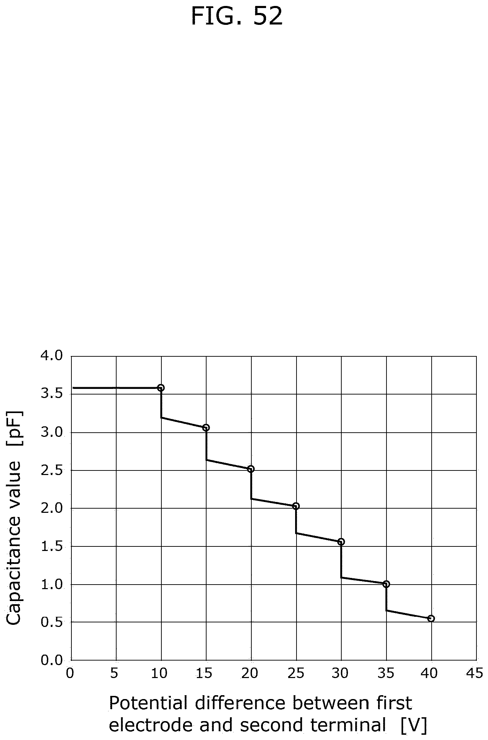

   FIG. 52 is a graph illustrating a change in the capacitance value with respect to the potential difference between the first electrode and the second terminal of the variable capacitance element in the example in FIG. 51 according to Embodiment 2.
[FIG. 53]

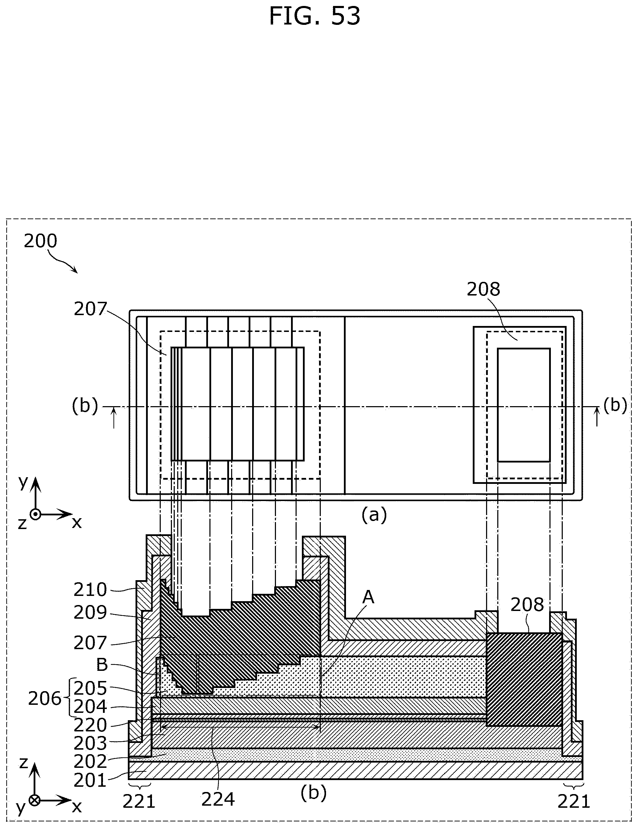

   FIG. 53 includes a plan view and a cross-sectional view that illustrate a configuration of a variable capacitance element in another example according to Embodiment 2.
[FIG. 54]

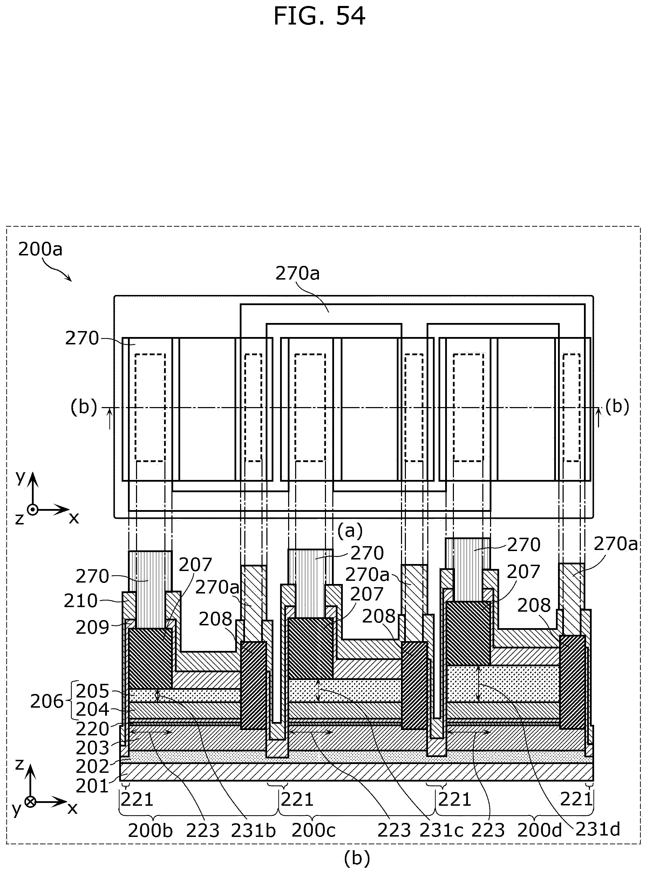

   FIG. 54 includes a plan view and a cross-sectional view that illustrate a configuration of a variable capacitance element according to a variation of Embodiment 2.

### [Description of Embodiments]

Embodiments in the present disclosure are described below with reference to the figures. It should be noted that the embodiments described below show specific examples of the present disclosure. Accordingly, the numerical values, shapes, materials, structural elements, the arrangement and connection of the structural elements, steps, order of the steps, and other descriptions indicated in the following embodiments are mere examples, and therefore do not intend to limit the present disclosure. Thus, among the structural elements described in the following embodiments, those not recited in any of the independent claims are described as optional structural elements.

Furthermore, the figures are schematic views and are not necessarily precise illustrations. Accordingly, the scales in the figures are not necessarily the same. In the figures, substantially the same elements are assigned the same reference symbol, and overlapping explanations are omitted or simplified.

Furthermore, in the Specification, the terms "above" and "below" used to describe a configuration of a variable capacitance element do not indicate the upward direction (vertically upward) or the downward direction (vertically downward) in absolute spatial recognition, but are terms determined in a relative positional relationship based on the stacking order of layers in a layered structure. Furthermore, the terms "above" and "below" are used not only when two structural elements are spaced apart from each other and another structural element is present between the two structural elements, but also when two structural elements are in tight contact with each other.

Furthermore, in the Specification and Drawings, the x-axis, the y-axis, and the z-axis indicate the three axes of a three-dimensional orthogonal coordinate system. In the embodiments, the z-axis direction is the vertical direction, and the direction perpendicular to the z-axis (the direction parallel to the x-y plane) is the horizontal direction. Furthermore, in the embodiments described below, the positive direction of the z-axis may be referred to as above, and the negative direction of the z-axis may be referred to as below.

Furthermore, the expression "in plan view" used in the Specification means that the substrate of the variable capacitance element is viewed in the positive direction of the z-axis.

### [Embodiment 1 - according to the claimed invention]

First, variable capacitance element 100 according to Embodiment 1 is described with reference to FIGS. 1, 2, and 3. FIG. 1 includes a plan view and a cross-sectional view that illustrate a configuration of variable capacitance element 100 according to Embodiment 1. FIG. 2 includes a plan view and a cross-sectional view that illustrate a state of variable capacitance element 100 according to Embodiment 1 when a voltage is applied. FIG. 3 includes a plan view and a cross-sectional view that illustrate a state of variable capacitance element 100 according to Embodiment 1 when a voltage is applied. More specifically, (a) in FIG. 1 is a plan view illustrating a configuration of variable capacitance element 100 according to Embodiment 1, and (b) in FIG. 1 is a cross-sectional view of variable capacitance element 100 at the position corresponding to line (b)-(b) in (a) in FIG. 1. (a) in FIG. 2 is a plan view illustrating a configuration of variable capacitance element 100 according to Embodiment 1, and (b) in FIG. 2 is a cross-sectional view of variable capacitance element 100 at the position corresponding to line (b)-(b) in (a) in FIG. 2. (a) in FIG. 3 is a plan view illustrating a configuration of variable capacitance element 100 according to Embodiment 1, and (b) in FIG. 3 is a cross-sectional view of variable capacitance element 100 at the position corresponding to line (b)-(b) in (a) in FIG. 3. FIGS. 2 and 3 illustrate a change when the voltage applied to variable capacitance element 100 in FIG. 1 is changed. The voltage applied to variable capacitance element 100 in FIG. 3 is greater than the voltage applied to variable capacitance element 100 in FIG. 2. It should be noted that (a) in FIG. 2 and (a) in FIG. 3 are transparent plan views of two-dimensional electron gas layers 120 when two-dimensional electron gas layers 120 illustrated in the cross-sectional views in (b) in FIG. 2 and in (b) in FIG. 3 are viewed in the height direction (in the z-axis direction).

As illustrated in (b) in FIG. 2, variable capacitance element 100 includes substrate 101, buffer layer 102, first semiconductor layer 103, dielectric layer 106, first electrode 107, and second terminal 108. Here, dielectric layer 106 is a stack of second semiconductor layer 104 and an insulating layer (here, first insulating layer 105).

Furthermore, variable capacitance element 100 includes two-dimensional electron gas layer 120, depletion layer region 122, isolation region 121, first protective insulating film 109, and second protective insulating film 110. More details are provided below.

Two-dimensional electron gas layer 120 is provided at the interface between first semiconductor layer 103 and second semiconductor layer 104. More specifically, two-dimensional electron gas layer 120 is provided on the first semiconductor layer 103 side of the heterointerface between second semiconductor layer 104 and first semiconductor layer 103. In other words, two-dimensional electron gas layer 120 is provided at or near the boundary between first semiconductor layer 103 and second semiconductor layer 104 (within 10 nm from the interface).

Depletion layer region 122 is formed in two-dimensional electron gas layer 120. Depletion layer region 122 is a region formed in second semiconductor layer 104, first semiconductor layer 103, and two-dimensional electron gas layer 120 by an electric field generated from the bottom surface of first electrode 107 according to the potential difference applied between first electrode 107 and second terminal 108. It should be noted that in (b) in FIG. 2 and in (b) in FIG. 3, depletion layer region 122 is the region surrounded by the dashed line.

Two-dimensional electron gas layer 120 below first electrode 107 functions as second electrode 123. Within two-dimensional electron gas layer 120 below first electrode 107, second electrode 123 is a region in which depletion due to expansion and contraction of depletion layer region 122 is not caused. That is, second electrode 123 is the region that is not depletion layer region 122 within two-dimensional electron gas layer 120 below first electrode 107.

It should be noted in (a) in FIG. 2 and in (a) in FIG. 3, a hatching pattern is given for identification to the region that is not depletion layer region 122 within two-dimensional electron gas layer 120.

In the outside region of first electrode 107 and second terminal 108, isolation region 121 is a region in which first semiconductor layer 103 and second semiconductor layer 104 have been removed and two-dimensional electron gas layer 120 is not provided. The outside region of first electrode 107 and second terminal 108 is present on the negative side of the x-axis relative to first electrode 107, on the positive side of the x-axis relative to second terminal 108, and on both positive and negative sides of the y-axis relative to first electrode 107 and second terminal 108. That is, the outside region of first electrode 107 and second terminal 108 has a rectangular frame shape.

First protective insulating film 109 and second protective insulating film 110 are sequentially provided above dielectric layer 106, first electrode 107, and second terminal 108.

Here, the direction from first electrode 107 toward second terminal 108 is a first direction (the positive direction of the x-axis). In other words, the first direction is the direction from the end position of the bottom surface of first electrode 107 on the side far from second terminal 108 toward the end position of the bottom surface of first electrode 107 on the side close to second terminal 108. Furthermore, in plan view of substrate 101, the direction orthogonal to the first direction is a second direction (y-axis direction). The interval between the bottom surface of first electrode 107 and the top surface of first semiconductor layer 103 monotonically increases in the first direction or in the second direction. That is, distance 134 between the bottom surface of first electrode 107 and the bottom surface of second semiconductor layer 104 monotonically increases in the first direction or in the second direction. It should be noted that FIGS. 1, 2, and 3 illustrate a monotonic increase in the interval in the first direction, and FIGS. 4 and 5, which are described later, illustrate a monotonic increase in the interval in the second direction.

The structural elements are described in more detail.

Substrate 101 is, for example, an Si substrate. Substrate 101 is not limited to an Si substrate and may be, for example, a Sapphire substrate, a SiC substrate, a GaN substrate, and an AIN substrate.

Buffer layer 102 is provided above substrate 101. Buffer layer 102 is, for example, a nitride semiconductor layer having a thickness of 2 µm. More specifically, buffer layer 102 is a nitride semiconductor layer having a layered structure including an AIN layer and an AlGaN layer. Alternatively, buffer layer 102 may be a single layer of a III-nitride semiconductor or layers of III-nitride semiconductors. Examples of III-nitride semiconductors include GaN, AlGaN, AlN, InGaN, and AlInGaN.

First semiconductor layer 103 is provided above substrate 101. In Embodiment 1, first semiconductor layer 103 is provided above buffer layer 102. First semiconductor layer 103 can contain, for example, undoped (i-type) GaN having a thickness of 200 nm. Undoped (i-type) means that impurities are intentionally not doped during epitaxial growth. Instead of GaN, first semiconductor layer 103 may be one of III-nitride semiconductors, such as AlGaN, InGaN, and AlInGaN. Furthermore, first semiconductor layer 103 may be not only an undoped (i-type) semiconductor but also a III-nitride semiconductor containing an n-type impurity, such as Si.

Second semiconductor layer 104 is provided above first semiconductor layer 103. Second semiconductor layer 104 is, for example, undoped (i-type) AlGaN having a thickness of 20 nm and a composition of 25% Al. It should be noted that the composition of 25% Al indicates Al_{0.25}Ga_{0.75}N.

It should be noted that second semiconductor layer 104 is not limited to AlGaN and may be one of III-nitride semiconductors, such as AlN, InGaN, and AlInGaN. Furthermore, second semiconductor layer 104 may contain n-type impurities.

Furthermore, as a cap layer, for instance, a GaN semiconductor layer having a thickness of at least around 1 nm and at most around 2 nm may be provided above second semiconductor layer 104. That is, such a cap layer may be provided between second semiconductor layer 104 and the insulating layer (here, first insulating layer 105).

In Embodiment 1, second semiconductor layer 104 has a band gap larger than that of first semiconductor layer 103. Furthermore, undoped (i-type) AlGaN second semiconductor layer 104 and undoped (i-type) GaN first semiconductor layer 103 form a heterostructure. That is, the interface between second semiconductor layer 104 and first semiconductor layer 103 is a heterojunction interface, and a hetero barrier is formed at the interface between second semiconductor layer 104 and first semiconductor layer 103.

As a result, two-dimensional electron gas layer 120 is provided on the first semiconductor layer 103 side of the heterointerface between second semiconductor layer 104 and first semiconductor layer 103.

It should be noted that as a spacer layer, for instance, an AIN semiconductor layer having a thickness of at least around 1 nm and at most around 2 nm may be provided between second semiconductor layer 104 and first semiconductor layer 103.

Isolation region 121 is provided in a semiconductor device to electrically isolate variable capacitance element 100 from other elements or electrically isolate variable capacitance elements 100 from one another. When viewed in plan view, isolation region 121 is the region that surrounds two-dimensional electron gas layer 120 and in which two-dimensional electron gas layer 120 is not provided.

For instance, isolation region 121 is provided by removing respective portions of second semiconductor layer 104, first semiconductor layer 103, and buffer layer 102.

It should be noted that isolation region 121 may be a filled region obtained by implanting molecules containing one of He, B, H, F, or Fe into two-dimensional electron gas layer 120. Furthermore, isolation region 121 may be formed by a combination of the method of removing the respective portions of second semiconductor layer 104, first semiconductor layer 103, and buffer layer 102 and a method of forming a filled region by implanting molecules containing one of He, B, H, F, or Fe into the region that remains after the removal of the respective portions.

First insulating layer 105, which is an example of an insulating layer, is provided above second semiconductor layer 104. For instance, first insulating layer 105 is SiₓN_{y} having a thickness of 270 nm, where x = 3, and y = 4.

It should be noted that in first insulating layer 105, the values of x and y indicating Si and N composition ratios, respectively may be different from the above-mentioned values. SiO₂, Al₂O₃, Ga₂O₃, TiO₂, Ta₂O₃, HfSiO₄, ZrSiO₄, HfO₂, ZrO₂, SrTiO₃, BaTiO₃, and other materials may be used as first insulating layer 105. First insulating layer 105 may be a single layer or stacked layers.

Dielectric layer 106 is a stack of second semiconductor layer 104 and first insulating layer 105. That is, dielectric layer 106 includes first insulating layer 105 as an insulating layer, and first insulating layer 105 is provided above second semiconductor layer 104. That is, dielectric layer 106 is provided above two-dimensional electron gas layer 120. In other words, dielectric layer 106 is provided above first semiconductor layer 103.

As illustrated in the cross-sectional view in (b) in FIG. 1, first electrode 107 is provided above dielectric layer 106 and contains an electrically conductive material. More specifically, first electrode 107 is provided above first insulating layer 105 included in dielectric layer 106.

For instance, first electrode 107 has a layered structure including a TiN layer having a film thickness of 50 nm and an Al layer having a film thickness of 500 nm. Here, the Al layer is provided above the TiN layer. Furthermore, in the plan view in (a) in FIG. 1, width 124 of first electrode 107 is 3.0 µm, and length 125 of first electrode 107 is 2.0 mm. Width 124 is a width in the x-axis direction, and length 125 is a length in the y-axis direction. It should be noted that first electrode 107 is not limited to the combination of TiN and Al. First electrode 107 may be a single-layer electrode film containing one of Ti, Al, Cu, Ni, Au, Pt, Pd, Ta, W, Si, Hf, and other metals or a multi-layer electrode film formed by a combination of at least two of the above metals.

Furthermore, first electrode 107 includes a first terminal. Here, in Embodiment 1, the first terminal corresponds to the top surface of first electrode 107. However, without being limited to the above example, the first terminal may be a portion that is electrically connected to first electrode 107 and supplies an electric potential.

As illustrated in the cross-sectional view in (b) in FIG. 1, second terminal 108 is provided in a region in which at least respective portions of dielectric layer 106, second semiconductor layer 104, and first semiconductor layer 103 have been removed, and is electrically connected to two-dimensional electron gas layer 120. Meanwhile, as illustrated in the plan view in (a) in FIG. 1, second terminal 108 is spaced apart from first electrode 107 and disposed parallel to first electrode 107. That is, in plan view of substrate 101, the longitudinal direction of first electrode 107 is parallel to that of second terminal 108. Here, the longitudinal directions are parallel to the y-axis direction. That is, in plan view of substrate 101, second terminal 108 is spaced apart from first electrode 107 and electrically connected to two-dimensional electron gas layer 120.

For instance, second terminal 108 has a layered structure obtained by alloying, through a thermal process, a stack of a Ti layer containing Ti having a thickness of 20 nm and an Al layer containing Al having a thickness of 200 nm. Here, the Al layer is provided above the Ti layer. In the plan view in (a) in FIG. 1, width 126 of second terminal 108 is 3.0 µm, and length 127 of second terminal 108 is 2.0 mm. Width 126 is a width in the x-axis direction, and length 127 is a length in the y-axis direction. It should be noted that second terminal 108 is not limited to the combination of Ti and Al. Second terminal 108 may be a single-layer electrode film containing one of Ti, Al, Cu, Ni, Au, Pt, Pd, Ta, W, Si, Hf, and other metals or a multi-layer electrode film formed of a combination of at least two of the above metals.

It should be noted that as long as second terminal 108 and two-dimensional electron gas layer 120 are electrically connected to each other, second semiconductor layer 104 need not be exposed. That is, in FIGS. 1 to 3, second terminal 108 passes through second semiconductor layer 104 in the y-axis direction and is in direct contact with two-dimensional electron gas layer 120. However, without being limited to the above example, second terminal 108 may be provided above second semiconductor layer 104 as long as second terminal 108 is electrically connected to two-dimensional electron gas layer 120.

As described above, as illustrated in FIGS. 1 to 3, in variable capacitance element 100, the interval between the bottom surface of first electrode 107 and the top surface of first semiconductor layer 103 monotonically increases in the first direction. Here, the thickness of first insulating layer 105, which is an example of an insulating layer included in dielectric layer 106, monotonically increases in the first direction. That is, dielectric layer 106 (more specifically, first insulating layer 105) in contact with the bottom surface of first electrode 107 has an inclined surface. Because of the inclined surface of dielectric layer 106, distance 134 between the bottom surface of first electrode 107 and the bottom surface of second semiconductor layer 104 monotonically increases from the end position of first electrode 107 on the side far from second terminal 108 toward the end position of first electrode 107 on the side close to second terminal 108. As illustrated in the cross-sectional view in (b) in FIG. 1, inclination angle θ 130 of the inclined surface is an angle formed by the inclined surface of the top surface of dielectric layer 106 and the line parallel to two-dimensional electron gas layer 120. It should be noted that in FIGS. 1 to 3, the line parallel to two-dimensional electron gas layer 120 is indicated by the dashed line, and (b) in FIG. 1, the sign, >> is given to show that the parallel line is parallel to two-dimensional electron gas layer 120.

The cross-sectional view in (b) in FIG. 1 illustrates film thickness 131 of first insulating layer 105 below the end position of first electrode 107 on the side far from second terminal 108 and film thickness 132 of first insulating layer 105 below the end position of first electrode 107 on the side close to second terminal 108. For instance, when the thickness of first insulating layer 105 linearly, monotonically increases from film thickness 131 of 10 nm to film thickness 132 of 270 nm, inclination angle θ 130 is 5 degrees. That is, in this case, when substrate 101 is viewed in cross section, the elevation angle that the bottom surface of first electrode 107 forms with the top surface of first semiconductor layer 103 is at least 5 degrees and at most 60 degrees. It should be noted that inclination angle θ 130 (that is, the elevation angle) is not limited to the above range and may be at least 10 degrees and at most 50 degrees or at least 20 degrees and at most 40 degrees.

First electrode 107 is covered by first protective insulating film 109 and second protective insulating film 110, and a given opening exposes a portion of first electrode 107. Here, the portion corresponds to the first terminal. Second terminal 108 is covered by second protective insulating film 110, and a given opening exposes a portion of second terminal 108.

Here, a phenomenon caused by applying a voltage between first electrode 107 and second terminal 108 is described with reference to FIGS. 2 and 3. As illustrated in FIGS. 2 and 3, depletion layer region 122 is formed in second semiconductor layer 104, first semiconductor layer 103, and two-dimensional electron gas layer 120 by an electric field generated from the bottom surface of first electrode 107 according to the potential difference applied between first electrode 107 and second terminal 108. In Embodiment 1, depletion layer region 122 has an electron concentration lower than or equal to 1e⁸/cm³. Furthermore, the potential difference applied between first electrode 107 and second terminal 108 is greater in the example in FIG. 3 than in the example in FIG. 2. Thus, depletion layer region 122 extends over a large area in the example in FIG. 3.

As illustrated in FIGS. 2 and 3, within two-dimensional electron gas layer 120 below first electrode 107, second electrode 123 is a region in which depletion due to expansion and contraction of depletion layer region 122 below first electrode 107 is not caused. In FIGS. 2 and 3, the length of second electrode 123 in the x-axis direction is indicated by the two-direction arrow. Furthermore, the potential difference applied between first electrode 107 and second terminal 108 is greater in the example in FIG. 3 than in the example in FIG. 2. Thus, in the example in FIG. 3, as a result of depletion layer region 122 extending over the large area, the area of second electrode 123 decreases.

In variable capacitance element 100 according to Embodiment 1, the interval between the bottom surface of first electrode 107 and the top surface of first semiconductor layer 103 monotonically increases in the first direction from first electrode 107 toward second terminal 108. That is, in Embodiment 1, distance 134 between the bottom surface of first electrode 107 and the bottom surface of second semiconductor layer 104 monotonically increases. Thus, the area that depletion layer region 122 extends within two-dimensional electron gas layer 120 changes, and the area of second electrode 123 changes, depletion layer region 122 being generated by an electric field generated from the bottom surface of first electrode 107 according to the potential difference applied between first electrode 107 and second terminal 108. That is, variable capacitance element 100 is achieved in which the area of second electrode 123 changes according to the magnitude of the potential difference between first electrode 107 and second terminal 108 and the capacitance value between first electrode 107 and second electrode 123 changes.

Here, with reference to FIG. 4, another example according to Embodiment 1 is described. FIG. 4 includes a plan view and a cross-sectional view that illustrate a configuration of variable capacitance element 100 in another example according to Embodiment 1. More specifically, (a) in FIG. 4 is a plan view illustrating a configuration of variable capacitance element 100 in another example according to Embodiment 1, and (b) in FIG. 4 is a cross-sectional view of variable capacitance element 100 at the position corresponding to line (b)-(b) in (a) in FIG. 4.

In variable capacitance element 100 according to the example, the interval between the bottom surface of first electrode 107 and the top surface of first semiconductor layer 103 monotonically increases in the second direction (the y-axis direction).

More specifically, in variable capacitance element 100 in the example, the interval between the bottom surface of first electrode 107 and the top surface of first semiconductor layer 103 monotonically increases in the positive direction of the y-axis.

Moreover, with reference to FIG. 5, another example according to Embodiment 1 is described. FIG. 5 includes a plan view and a cross-sectional view that illustrate a configuration of variable capacitance element 100 in another example according to Embodiment 1. (a) in FIG. 5 is a plan view illustrating a configuration of variable capacitance element 100 in another example according to Embodiment 1, and (b) in FIG. 5 is a cross-sectional view of variable capacitance element 100 at the position corresponding to line (b)-(b) in (a) in FIG. 5.

In variable capacitance element 100 according to the example, the interval between the bottom surface of first electrode 107 and the top surface of first semiconductor layer 103 monotonically increases in the second direction (the y-axis direction).

More specifically, in variable capacitance element 100 in the example, the interval between the bottom surface of first electrode 107 and the top surface of first semiconductor layer 103 monotonically increases in the negative direction of the y-axis.

Furthermore, effects similar to those obtained in the monotonic increase in the interval in the first direction, which is described above, are obtained also in a structure having a monotonic increase in the interval in the second direction as illustrated in FIGS. 4 and 5. That is, each of variable capacitance elements 100 illustrated in FIGS. 4 and 5 is also achieved as variable capacitance element 100 in which the area of second electrode 123 changes according to the magnitude of the potential difference between first electrode 107 and second terminal 108 and the capacitance value between first electrode 107 and second electrode 123 changes.

Furthermore, FIG. 6 is a graph illustrating a change in the capacitance value with respect to the potential difference between first electrode 107 and second terminal 108 of variable capacitance element 100 according to Embodiment 1. It should be noted that FIG. 6 is a graph relating to variable capacitance element 100 described with reference to FIGS. 1, 2, and 3. For instance, as illustrated in FIG. 6, when the potential difference between first electrode 107 and second terminal 108 is within the range from 10 to 40 V, the capacitance value between first electrode 107 and second electrode 123 indicates a change from 0.1 to 3.8 pF. It should be noted that the graph in FIG. 6 showing the capacitance value with respect to the potential difference is based on simplified calculation in which only the capacitance component in the direction perpendicular to second electrode 123 (that is, the z-axis direction) is taken into consideration, and there are some differences from the results of an actual operation. As described above, in variable capacitance element 100 according to Embodiment 1, dielectric layer 106 includes an insulating layer (e.g., first insulating layer 105). Thus, as illustrated in FIG. 6, a large potential of at least 10 V and at most 40 V can be applied between first electrode 107 and second terminal 108. That is, it is possible to improve the insulation withstand voltage of variable capacitance element 100.

FIG. 7 is a figure to compare a graph and plan views, the graph illustrating a change in the capacitance value with respect to the potential difference between first electrode 107 and second terminal 108 of variable capacitance element 100 according to Embodiment 1, the plan views illustrating the states when a voltage is applied. (b) in FIG. 7 is a graph showing a change in the capacitance value with respect to the potential difference between first electrode 107 and second terminal 108, and thus corresponds to FIG. 6. It should be noted that (a) in FIG. 7 is a plan view of variable capacitance element 100 when the potential difference in the graph is 15 V. The plan view of variable capacitance element 100 illustrated in FIG. 2 is a specific example. Furthermore, (c) in FIG. 7 is a plan view of variable capacitance element 100 when the potential difference in the graph is 35 V. The plan view of variable capacitance element 100 illustrated in FIG. 3 is a specific example.

In variable capacitance element 100 according to the present disclosure described above, distance 134 between the bottom surface of first electrode 107 and the bottom surface of second semiconductor layer 104 monotonically increases from the side far from second terminal 108 toward the side close to second terminal 108. This makes it possible to obtain a change in the capacitance value according to the potential difference between first electrode 107 and second terminal 108, without using control by an additional terminal.

Furthermore, the monotonic increase in distance 134 between the bottom surface of first electrode 107 and the bottom surface of second semiconductor layer 104 from the side far from second terminal 108 toward the side close to second terminal 108, enables calculation of a relationship between: the capacitance value between first electrode 107 and second electrode 123, and the potential difference applied between first electrode 107 and second terminal 108. Thus, quantitative calibration of the capacitance value is easier when compared to the conventional technology.

Furthermore, in variable capacitance element 100 according to the present disclosure described above, the larger inclination angle θ 130 of dielectric layer 106 is, a greater potential difference between first electrode 107 and second terminal 108 is necessary to change the area of second electrode 123. Accordingly, when inclination angle θ 130 of dielectric layer 106 is large, even if an electric potential to control the capacitance value has a signal amplitude or is unstable, it is possible to control the change in the capacitance value to be within a predetermined range. It should be noted that the case in which the electric potential to control the capacitance value has a signal amplitude or is unstable, is, for instance, a case in which an alternating voltage is superimposed on the electric potential to control the capacitance value. As described in Embodiment 1, when inclination angle θ 130 is 5 degrees, inclination angle θ 130 is large. FIG. 8 is a graph illustrating a change in the capacitance value with respect to the potential difference between first electrode 107 and second terminal 108 of variable capacitance element 100 according to Embodiment 1. It should be noted as with FIG. 6, FIG. 8 is a graph relating to variable capacitance element 100 described with reference to FIGS. 1, 2, and 3. As seen in the change in the capacitance value with respect to the voltage when inclination angle θ 130 according to Embodiment 1 is 5 degrees, which is illustrated in FIG. 8, approximation straight lines (a) to (c) illustrated in FIG. 8 indicate a range within which the capacitance value changes keeping linearity. In FIG. 8, with respect to a change of 1 V in a central potential difference of each approximation straight line, the amount of change in the capacitance value can be controlled to be within 10% with respect to the capacitance value for the central potential difference. It should be noted that the central potential difference of an approximation straight line means the average value of two potential differences corresponding to both ends of the approximation straight line. The amount of change in the capacitance value with respect to the change in the potential difference (that is, for example, a change of 1 V in the central potential difference of an approximation straight line) can be decreased by increasing inclination angle θ 130. Here, when inclination angle θ 130 is at least 5 degrees and at most 60 degrees, it is possible to decrease the amount of change in the capacitance value with respect to the change in the potential difference. It should be noted that the graph in FIG. 8 showing the capacitance value with respect to the potential difference is based on simplified calculation in which only the capacitance component in the direction perpendicular to second electrode 123 (that is, the z-axis direction) is taken into consideration, and there are some differences from the results of an actual operation.

As illustrated in FIG. 8, in variable capacitance element 100 according to Embodiment 1, the capacitance value changes significantly with respect to an applied voltage, the change is a linear change with respect to the voltage, and even with addition of an amplitude signal to a capacitance control voltage, the capacitance value can be controlled to be within a predetermined range.

Here, with reference to FIG. 9, another example according to Embodiment 1 is described. FIG. 9 includes a plan view and a cross-sectional view that illustrate a configuration of variable capacitance element 100 in another example according to Embodiment 1. (a) in FIG. 9 is a plan view illustrating a configuration of variable capacitance element 100 in another example according to Embodiment 1, and (b) in FIG. 9 is a cross-sectional view of variable capacitance element 100 at the position corresponding to line (b)-(b) in (a) in FIG. 9. As illustrated in FIG. 9, in variable capacitance element 100, the insulating layer may include first insulating layer 105 and second insulating layer 111. That is, the insulating layer may include first insulating layer 105 and second insulating layer 111 that has an insulation withstand voltage higher than that of first insulating layer 105. In this case, dielectric layer 106 includes second semiconductor layer 104 and, as insulating layers, first insulating layer 105 and second insulating layer 111. As described above, first insulating layer 105 contains Si₃N₄. Thus, specifically, the use range of the capacitance control voltage can be expanded by using, as second insulating layer 111, SiO₂ having an insulation withstand voltage higher than that of Si₃N₄. That is, it is possible to improve the insulation withstand voltage of variable capacitance element 100. It is possible to improve the insulation withstand voltage of variable capacitance element 100, also by stacking Si₃N₄ and SiO₂ as second insulating layer 111. The effects of the improved insulation withstand voltage are obtained also by using, as second insulating layer 111, a high insulation withstand voltage material such as AlN or Al₂O₃ having a high insulation withstand voltage. Here, as an example, the cross-sectional view in (b) in FIG. 9 illustrates that first insulating layer 105 is provided above second insulating layer 111.

As described above, the interval between the bottom surface of first electrode 107 and the top surface of first semiconductor layer 103 monotonically increases. It should be noted that the degree of increase indicating a degree of monotonic increase in the interval need not be constant. For instance, the degree of increase may become smaller with an increase in the interval between the bottom surface of first electrode 107 and the top surface of first semiconductor layer 103. Such an example is described with reference to FIG. 10. FIG. 10 includes a plan view and a cross-sectional view that illustrate a configuration of variable capacitance element 100 in another example according to Embodiment 1. (a) in FIG. 10 is a plan view illustrating a configuration of variable capacitance element 100 in another example according to Embodiment 1, and (b) in FIG. 10 is a cross-sectional view of variable capacitance element 100 at the position corresponding to line (b)-(b) in (a) in FIG. 10. The degree of increase is also the magnitude of the inclination of the interface at which the bottom surface of first electrode 107 is in contact with the top surface of first insulating layer 105, when variable capacitance element 100 is viewed in cross section. In other words, the degree of increase is also the degree of increase in the interval per unit length in the first direction (the x-axis direction). For instance, as illustrated in (a) and (b) in FIG. 10, in variable capacitance element 100, the inclination of first insulating layer 105 may have, below first electrode 107, inclination angle Φ 133 in the middle position of first electrode 107, in addition to inclination angle θ 130 at the end position of first electrode 107. That is, the degree of increase indicating the degree of monotonic increase in the interval is not constant. FIG. 11 is a graph illustrating a change in the capacitance value with respect to the potential difference between first electrode 107 and second terminal 108 of variable capacitance element 100 in another example according to Embodiment 1. More specifically, FIG. 11 is a graph relating to variable capacitance element 100 described with reference to FIG. 10. In this case, under the condition that inclination angle θ 130 > inclination angle Φ 133, as illustrated in FIG. 11, the linearity of the change in capacitance with respect to the voltage can be maintained in a wide range. Furthermore, in variable capacitance element 100 illustrated in FIG. 11, the degree of increase is not constant. Specifically, there are two degrees of increase (that is, inclinations of the interface at which the bottom surface of first electrode 107 is in contact with the top surface of first insulating layer 105). The position at which the two inclinations of the interface meet is referred to as the changing point of the inclination angle. To maintain the linearity in a wider range, the number of change points of an inclination angle in the middle position of first electrode 107 may be increased. It should be noted that the graph in FIG. 11 showing the capacitance value with respect to the potential difference is based on simplified calculation in which only the capacitance component in the direction perpendicular to second electrode 123 (the z-axis direction) is taken into consideration, and there are some differences from the results of an actual operation.

It should be noted that the thickness of second semiconductor layer 104 may monotonically increase in the first direction. FIG. 12 includes a plan view and a cross-sectional view that illustrate a configuration of variable capacitance element 100 in another example according to Embodiment 1. (a) in FIG. 12 is a plan view illustrating a configuration of variable capacitance element 100 in another example according to Embodiment 1, and (b) in FIG. 12 is a cross-sectional view of variable capacitance element 100 at the position corresponding to line (b)-(b) in (a) in FIG. 12. In variable capacitance element 100 in the example, as illustrated in (a) and (b) in FIG. 12, dielectric layer 106 does not include first insulating layer 105 and includes only second semiconductor layer 104. The thickness of second semiconductor layer 104 may monotonically increase from the side far from second terminal 108 toward the side close to second terminal 108. When second semiconductor layer 104 contains AlGaN and dielectric layer 106 including only such second semiconductor layer 104 is provided, dielectric layer 106 (that is, second semiconductor layer 104) serves as a material having permittivity higher than that of Si₃N₄. Thus, it is possible to achieve variable capacitance element 100 in which the capacitance value per unit area is high.

Here, with reference to FIG. 13, another example according to Embodiment 1 is described. FIG. 13 is a cross-sectional view illustrating a configuration of variable capacitance element 100 in another example according to Embodiment 1. In variable capacitance element 100 in the example, as illustrated in FIG. 13, first electrode 107 may include a region not in direct contact with dielectric layer 106 and provided above first protective insulating film 109. That is, a portion of first protective insulating film 109 may be present between dielectric layer 106 and first electrode 107. It should be noted that here the portion of first protective insulating film 109 that is present between dielectric layer 106 and dielectric layer 106 is provided on both the negative and positive sides of the x-axis of first electrode 107. Likewise, as illustrated in FIG. 13, second terminal 108 may include a region formed above dielectric layer 106. The above structure of variable capacitance element 100 mitigates electric field concentration between first electrode 107 and second electrode 123, which can improve the insulation withstand voltage between first electrode 107 and second electrode 123. Although not illustrated in FIG. 13, a portion of first electrode 107 on the side far from second terminal 108 may be in contact with second semiconductor layer 104. In this case, a portion of first electrode 107 on the side close to second terminal 108 is in contact with first insulating layer 105. By bringing the portion of first electrode 107 on the side far from second terminal 108 into contact with second semiconductor layer 104, dielectric layer 106 including only second semiconductor layer 104 having a large permittivity is provided. Thus, it is possible to achieve variable capacitance element 100 having a higher capacitance value.

Moreover, with reference to FIG. 14, another example according to Embodiment 1 is described. FIG. 14 includes a plan view and a cross-sectional view that illustrate a configuration of variable capacitance element 100 in another example according to Embodiment 1. (a) in FIG. 14 is a plan view illustrating a configuration of variable capacitance element 100 in another example according to Embodiment 1, and (b) in FIG. 14 is a cross-sectional view of variable capacitance element 100 at the position corresponding to line (b)-(b) in (a) in FIG. 14. As illustrated in FIG. 14, variable capacitance element 100 includes field plate electrode 112 provided above second protective insulating film 110 and between first electrode 107 and second terminal 108. More specifically, a portion of field plate electrode 112 is provided between first electrode 107 and second terminal 108. Furthermore, another portion of field plate electrode 112 is provided above first electrode 107. It should be noted that in variable capacitance element 100 in the example, field plate electrode 112 is not connected to first electrode 107. As illustrated in FIG. 14, field plate electrode 112 is connected to the ground potential. That is, the electric potential of field plate electrode 112 is set to the ground potential.

Moreover, with reference to FIG. 15, another example according to Embodiment 1 is described. FIG. 15 includes a plan view and a cross-sectional view that illustrate a configuration of variable capacitance element 100 in another example according to Embodiment 1. (a) in FIG. 15 is a plan view illustrating a configuration of variable capacitance element 100 in another example according to Embodiment 1, and (b) in FIG. 15 is a cross-sectional view of variable capacitance element 100 at the position corresponding to line (b)-(b) in (a) in FIG. 15. As illustrated in FIG. 15, variable capacitance element 100 in the example includes field plate electrode 112 provided between first electrode 107 and second terminal 108. More specifically, a portion of field plate electrode 112 is provided between first electrode 107 and second terminal 108. Furthermore, field plate electrode 112 is provided above first electrode 107 and second protective insulating film 110. As illustrated in FIG. 15, field plate electrode 112 is connected to first electrode 107. That is, field plate electrode 112 covers the entire top surface (that is, the first terminal) of first electrode 107 and is in contact with the top surface of first electrode 107. Thus, field plate electrode 112 is set to the electric potential of first electrode 107.

Moreover, with reference to FIG. 16, another example according to Embodiment 1 is described. FIG. 16 includes a plan view and a cross-sectional view that illustrate a configuration of variable capacitance element 100 in another example according to Embodiment 1. (a) in FIG. 16 is a plan view illustrating a configuration of variable capacitance element 100 in another example according to Embodiment 1, and (b) in FIG. 16 is a cross-sectional view of variable capacitance element 100 at the position corresponding to line (b)-(b) in (a) in FIG. 16. Variable capacitance element 100 illustrated in FIG. 16 has the same configuration as variable capacitance element 100 illustrated in FIG. 15 except that field plate electrode 112 covers a portion of the top surface (that is, the first terminal) of first electrode 107 and is in contact with the top surface. Furthermore, in variable capacitance elements 100 illustrated in FIGS. 15 and 16, as described above, a portion of field plate electrode 112 is provided between first electrode 107 and second terminal 108. Still another portion of field plate electrode 112 may be provided above isolation region 121.

In this way, variable capacitance element 100 may include field plate electrode 112. This, a large potential difference between first electrode 107 and second terminal 108 becomes a cause of electron trapping in an impurity level generated at the end positions of first electrode 107, which can mitigate electric field concentration on the end positions of first electrode 107. As a result, the capacitance value can change with respect to the change in the controlled electric potential of variable capacitance element 100, without delay.

With reference to FIGS. 17 to 29, a method of manufacturing variable capacitance element 100 in Embodiment 1 is described below. FIGS. 17 to 29 are cross-sectional views illustrating structures of variable capacitance element 100 during a manufacturing process. Here, a method of manufacturing of variable capacitance elements 100 illustrated in FIGS. 1, 2, and 3 is described.

As illustrated in FIG. 17, buffer layer 102, first semiconductor layer 103, and second semiconductor layer 104 are sequentially epitaxially grown above Si substrate 101 in the positive c-plane direction (<0001> direction), by metal organic chemical vapor deposition (MOCVD). Buffer layer 102 has a thickness of 2 µm and a layered structure including an AIN layer and an AlGaN layer. First semiconductor layer 103 has a thickness of 200 nm and contains i-type GaN. Second semiconductor layer 104 has a thickness of 20 nm and contains i-type AlGaN having a composition of 25% Al.

A high-concentration two-dimensional electron gas is generated on the first semiconductor layer 103 side of the heterointerface between first semiconductor layer 103 and second semiconductor layer 104, and two-dimensional electron gas layer 120 is formed.

Then, first insulating layer 105 is formed by depositing 270 nm thick SiₓN_{y} above second semiconductor layer 104 by plasma chemical vapor deposition (CVD), where x = 3, y = 4.

It should be noted that SiₓN_{y} having different Si and N composition ratios may be used as SiN, or one of materials such as SiO₂, Al₂O₃, Ga₂O₃, TiO₂, Ta₂O₃, HfSiO₄, ZrSiO₄, HfO₂, ZrO₂, SrTiO₃, and BaTiO₃ may be used. Furthermore, the film formation method is not limited to plasma CVD, and thermal CVD, reactive sputtering, or atomic layer deposition (ALD) may be used.

By depositing first insulating layer 105, dielectric layer 106 including second semiconductor layer 104 and first insulating layer 105 is formed.

Then, as illustrated in FIG. 18, a mask for forming isolation region 121 is formed using photoresist 141. Then, isolation region 121 is formed by removing respective portions of first insulating layer 105, second semiconductor layer 104, first semiconductor layer 103, and buffer layer 102 by dry etching using photoresist 141 as a mask.

Furthermore, instead of etching, isolation region 121 may be formed by implanting, by an ion implanter, molecules containing one of He, B, H, F, or Fe into respective portions of second semiconductor layer 104, first semiconductor layer 103, and buffer layer 102.

Then, as illustrated in FIG. 19, through an exposure and development process after resist coating and a thermal process, the inclined surface of photoresist 142 is formed so that the film thickness of photoresist 142 increases from the end position of first electrode 107 on the side far from second terminal 108 toward the end position of first electrode 107 on the side close to second terminal 108, the end positions being included in the end positions of first electrode 107 spaced apart from second terminal 108.

Then, as illustrated in FIG. 20, first insulating layer 105 is etched in accordance with the inclined surface of photoresist 142 by dry etching using photoresist 142 as a mask. In this way, the inclined surface of first insulating layer 105 is formed.

It should be noted that in addition to an inclination angle formed by photoresist 142 itself, inclination angle θ 130 illustrated in (b) in FIG. 1 may be controlled by a difference in the etching rate between photoresist 142 and first insulating layer 105. Furthermore, a gas containing one of C, F, Ar, or H may be used as an etching gas used for dry etching.

Furthermore, a predetermined angle formed by the inclined surface of photoresist 142 can be obtained by controlling the temperature of the thermal process performed after the exposure and development process for photoresist 142. Specifically, the inclination angle of photoresist 142 can be decreased by increasing the temperature of the thermal process. Furthermore, the inclination angle of photoresist 142 can be decreased by decreasing the film thickness of photoresist 142.

Then, as illustrated in FIG. 21, TiN and Al are sequentially deposited as first metal layer 301 by sputtering, and a mask for forming first electrode 107 is formed using photoresist 143.

Then, as illustrated in FIG. 22, by removing TiN and Al by dry etching using photoresist 143 as a mask, first electrode 107 is formed above the inclined surface of dielectric layer 106. That is, first metal layer 301 that remains after the dry etching serves as first electrode 107.

It should be noted that the method of forming first electrode 107 may be a formation method in which an electrode material is evaporated onto a photoresist having an opening for only the pattern of first electrode 107 and then the photoresist, together with the electrode material adhering to the non-open portion of the resist, is stripped off with an organic chemical liquid or adhesive tape.

Then, as illustrated in FIG. 23, first protective insulating film 109 is deposited.

Then, as illustrated in FIG. 24, a mask for forming an opening for providing second terminal 108 is formed using photoresist 144.

Then, as illustrated in FIG. 25, respective portions of first protective insulating film 109, first insulating layer 105, second semiconductor layer 104, and first semiconductor layer 103 are removed by dry etching using photoresist 144 as a mask.

Then, as illustrated in FIG. 26, Ti and Al are sequentially deposited as second metal layer 302 by sputtering, and a mask for forming second terminal 108 is formed using photoresist 145.

Then, as illustrated in FIG. 27, Ti and Al are removed by drying etching using photoresist 145 as a mask. Moreover, after photoresist 145 is removed, Ti and Al deposited through the thermal process are alloyed, which forms second terminal 108 that can make ohmic contact with two-dimensional electron gas layer 120.

It should be noted that the method of forming second terminal 108 may be a formation method in which in a region to form second terminal 108, an electrode material is evaporated onto a resist having an opening for the pattern of second terminal 108 and, then the resist, together with the electrode material adhering to the non-open portion of the resist, is stripped off with an organic chemical liquid. Furthermore, as long as second terminal 108 can form an ohmic junction with two-dimensional electron gas layer 120, respective portions of second semiconductor layer 104 and first semiconductor layer 103 need not be removed. For instance, an ohmic junction may be formed by adding and implanting n-type impurities typified by Si into the semiconductor layers below second terminal 108 (that is, both first semiconductor layer 103 and second semiconductor layer 104, or second semiconductor layer 104). Furthermore, the metal of second terminal 108 may be diffused close to two-dimensional electron gas layer 120 by a thermal process.

Then, as illustrated in FIG. 28, after second protective insulating film 110 is deposited, a mask for forming an opening above each of first electrode 107 and second terminal 108 is formed using photoresist 146.

Then, as illustrated in FIG. 29, after first protective insulating film 109 and second protective insulating film 110 are removed by dry etching using photoresist 146 as a mask, photoresist 146 is removed. In this way, variable capacitance element 100 according to Embodiment 1 in the present disclosure is manufactured.

Moreover, with reference to FIGS. 30 and 31, another method of manufacturing variable capacitance element 100 in Embodiment 1 is described. FIGS. 30 and 31 are cross-sectional views illustrating structures of variable capacitance element 100 during another manufacturing process. As illustrated in FIGS. 30 and 31, photoresist 147 is formed that does not include a region to form electrode 107 and includes a resist opening pattern having an opening. The resist opening pattern is wet-etched by a chemical liquid. The inclined surface of first insulating layer 105 is formed by side etching a portion outside the resist opening pattern. Furthermore, a chemical liquid containing one of hydrogen fluoride, phosphoric acid, sulfuric acid, ammonia, or hydrogen peroxide water may be used as the chemical liquid used in the wet etching. That is, the method described with reference to FIGS. 30 and 31 may be used instead of the method of forming the inclined surface of first insulating layer 105 described with reference to FIGS. 19 and 20.

### [Embodiment 2 - according to the claimed invention]

Then, variable capacitance element 200 according to Embodiment 2 is described with reference to FIGS. 32 to 35. FIG. 32 includes a plan view and a cross-sectional view that illustrate a configuration of variable capacitance element 200 according to Embodiment 2. FIG. 33 includes a plan view and a cross-sectional view that illustrate a state of variable capacitance element 200 according to Embodiment 2 when a voltage is applied. FIG. 34 includes a plan view and a cross-sectional view that illustrate a state of variable capacitance element 200 according to Embodiment 2 when a voltage is applied. FIG. 35 is a cross-sectional view illustrating a detailed configuration of variable capacitance element 200 according to Embodiment 2. More specifically, (a) in FIG. 32 is a plan view illustrating a configuration of variable capacitance element 200 according to Embodiment 2, and (b) in FIG. 32 is a cross-sectional view of variable capacitance element 200 at the position corresponding to line (b)-(b) in (a) in FIG. 32. (a) in FIG. 33 is a plan view illustrating a configuration of variable capacitance element 200 according to Embodiment 2, and (b) in FIG. 33 is a cross-sectional view of variable capacitance element 200 at the position corresponding to line (b)-(b) in (a) in FIG. 33. (a) in FIG. 34 is a plan view illustrating a configuration of variable capacitance element 200 according to Embodiment 2, and (b) in FIG. 34 is a cross-sectional view of variable capacitance element 200 at the position corresponding to line (b)-(b) in (a) in FIG. 34. Moreover, (a) and (b) in FIG. 33 and (a) and (b) in FIG. 34 illustrate a change when a voltage applied to variable capacitance element 200 in the plan view and the cross-sectional view illustrated in (a) and (b) FIG. 32 is changed. The voltage applied to variable capacitance element 200 illustrated in FIG. 34 is greater than the voltage applied to variable capacitance element 200 illustrated in FIG. 33. It should be noted that (a) in FIG. 33 and (a) and FIG. 34 are transparent plan views of two-dimensional electron gas layers 220 when two-dimensional electron gas layers 220 illustrated in (b) in FIG. 33 and in (b) in FIG. 34 are viewed in the height direction (in the z-axis direction). FIG. 35 shows an example for describing in more detail variable capacitance element 200 according to Embodiment 2 illustrated in (b) in FIG. 32. In Embodiment 2, the interval between the bottom surface of first electrode 207 and the top surface of first semiconductor layer 203 monotonically increases in the first direction, and the degree of increase indicating the degree of monotonic increase in the interval is not constant. For instance, a monotonic increase in the surface of first insulating layer 205 below first electrode 207 is a discontinuous increase. It should be noted that in Embodiment 2, detailed explanations for structural elements in common with Embodiment 1 are omitted.

As illustrated in (b) in FIG. 33, variable capacitance element 200 includes substrate 201, buffer layer 202, first semiconductor layer 203, dielectric layer 206, first electrode 207, and second terminal 208. Here, dielectric layer 206 is a stack of second semiconductor layer 204 and an insulating layer (here, first insulating layer 205).

Furthermore, variable capacitance element 200 includes two-dimensional electron gas layer 220, depletion layer region 222, isolation region 221, first protective insulating film 209, and second protective insulating film 210. More details are provided below.

Two-dimensional electron gas layer 220 is provided at the interface between first semiconductor layer 203 and second semiconductor layer 204. More specifically, two-dimensional electron gas layer 220 is provided on the first semiconductor layer 203 side of the heterointerface between second semiconductor layer 204 and first semiconductor layer 203. In other words, two-dimensional electron gas layer 220 is provided at or near the boundary between first semiconductor layer 203 and second semiconductor layer 204 (within 30 nm from the interface).

Depletion layer region 222 is formed in two-dimensional electron gas layer 220. Depletion layer region 222 is a region formed in second semiconductor layer 204, first semiconductor layer 203, and two-dimensional electron gas layer 220 by an electric field generated from the bottom surface of first electrode 207 according to the potential difference applied between first electrode 207 and second terminal 208. It should be noted that in (b) in FIG. 33 and in (b) in FIG. 34, depletion layer region 222 is the region surrounded by the dashed line.

A portion of two-dimensional electron gas layer 220 functions as second electrode 223. Within two-dimensional electron gas layer 220 below first electrode 207, second electrode 223 is a region in which depletion due to expansion and contraction of depletion layer region 222 is not caused. That is, second electrode 223 is the region that is not depletion layer region 222 within two-dimensional electron gas layer 220 below first electrode 207. It should be noted in (a) in FIG. 33 and in (a) in FIG. 34, a hatching pattern is given for identification to the region that is not depletion layer region 222 within two-dimensional electron gas layer 220.

In the outside region of first electrode 207 and second terminal 208, isolation region 221 is a region in which first semiconductor layer 203 and second semiconductor layer 204 have been removed and two-dimensional electron gas layer 220 is not provided.

First protective insulating film 209 and second protective insulating film 210 are sequentially provided above dielectric layer 206, first electrode 207, and second terminal 208.

Furthermore, as with Embodiment 1, width 224 of first electrode 207 is 3.0 µm, length 225 of first electrode 207 is 2.0 mm, width 226 of second terminal 208 is 3.0 µm, and length 227 of second terminal 208 is 2.0 mm.

That is, the structural elements of variable capacitance element 200 according to Embodiment 2 are assigned the reference signs in the 200s, which are changed from the reference signs (in the 100s) of the structural elements of variable capacitance element 100 according to Embodiment 1.

Also in Embodiment 2, the first direction is the direction from first electrode 207 toward second terminal 208 (the positive direction of the x-axis). In other words, the first direction is the direction from the end position of the bottom surface of first electrode 207 on the side far from second terminal 208 toward the end position of the bottom surface of first electrode 207 on the side close to second terminal 208. Furthermore, in plan view of substrate 201, the second direction is the direction orthogonal to the first direction (y-axis direction).

In variable capacitance element 200, the interval between the bottom surface of first electrode 207 and the top surface of first semiconductor layer 203 monotonically increases in the first direction or in the second direction, and the degree of increase indicating the degree of monotonic increase in the interval is not constant. That is, for instance, distance 234 between the bottom surface of first electrode 207 and the bottom surface of second semiconductor layer 204 stepwisely, discontinuously increases in the first direction or in the second direction. It should be noted that in the example described here, the interval monotonically increases in the first direction.

Dielectric layer 206 in contact with the bottom surface of first electrode 207 has steps indicating a discontinuous increase in the film thickness as illustrated in (b) in FIG. 32, from the end position of first electrode 207 on the side far from second terminal 208 toward the end position of first electrode 207 on the side close to second terminal 208. That is, the bottom surface of first electrode 207 has steps including multiple step surfaces. It should be noted that each of the step surfaces is a surface parallel to the x-y plane. Details of the steps are described below. For instance, as illustrated in FIG. 35, width 224 of first electrode 207 is divided into the six widths, first width 251, second width 252, third width 253, fourth width 254, fifth width 255, and sixth width 256 in accordance with the steps of first insulating layer 205. Here, first width 251 is 0.25 µm, each of second width 252 to fifth width 255 is 0.50 µm, and sixth width 256 is 0.25 µm. Furthermore, first width 251 to sixth width 256 are the lengths of the multiple step surfaces in the first direction (the x-axis direction).

Furthermore, when dielectric layer 206 has the above shape, film thicknesses 231 and 232 of first insulating layer 205 illustrated in the cross-sectional view in (b) in FIG. 32 are described below. Film thickness 231 of first insulating layer 205 below the end position of first electrode 207 on the side far from second terminal 208 is, for example, 10 nm. Film thickness 232 of first insulating layer 205 below the end position of first electrode 207 on the side close to second terminal 208 is, for example, 270 nm.

Here, a phenomenon caused by applying a voltage between first electrode 207 and second terminal 208 is described with reference to (a) and (b) in FIG. 33 and (a) and (b) in FIG. 34. As illustrated in the figures, depletion layer region 222 is formed in second semiconductor layer 204, first semiconductor layer 203, and two-dimensional electron gas layer 220 by an electric field generated from the bottom surface of first electrode 207 according to the potential difference applied between first electrode 207 and second terminal 208. In Embodiment 2, depletion layer region 222 has an electron concentration lower than or equal to 1e⁸/cm³. It should be noted that an applied voltage difference is larger in the example in FIG. 33 than in the example in FIG. 34, and thus depletion layer region 222 extends over a large area in the example in FIG. 34.

As illustrated in (a) and (b) in FIG. 33 and in (a) and (b) in FIG. 34, within two-dimensional electron gas layer 220 below first electrode 207, second electrode 223 is a region in which depletion due to expansion and contraction of depletion layer region 222 below first electrode 207 is not caused. In FIGS. 33 and 34, the length of second electrode 223 in the x-axis direction is indicated by the two-direction arrow. As described above, the applied voltage difference between first electrode 207 and second terminal 208 is larger in the example in FIG. 34 than in the example in FIG. 33. Thus, in the example in FIG. 34, as a result of depletion layer region 222 extending over a large area, the area of second electrode 223 decreases.

A specific method of manufacturing variable capacitance element 200 according to the present disclosure is described with reference to the cross-sectional views illustrated in FIGS. 36 to 48, the cross-sectional views illustrating respective steps in an example of the method of manufacturing variable capacitance element 200 according to the present disclosure. FIGS. 36 to 48 are cross-sectional views illustrating structures of variable capacitance element 200 according to Embodiment 2 during a manufacturing process.

As illustrated in FIG. 36, buffer layer 202, first semiconductor layer 203, and second semiconductor layer 204 are sequentially epitaxially grown above Si substrate 201 in the positive direction of the c-plane (<0001> direction), by metal organic chemical vapor deposition. Buffer layer 202 has a thickness of 2 µm and a layered structure including an AIN layer and an AlGaN layer. First semiconductor layer 203 has a thickness of 200 nm and contains i-type GaN. Second semiconductor layer 204 has a thickness of 20 nm and contains i-type AlGaN having a composition of 25% Al.

A high-concentration two-dimensional electron gas is generated on the first semiconductor layer 203 side of the heterointerface between first semiconductor layer 203 and second semiconductor layer 204, and two-dimensional electron gas layer 220 is formed.

Then, first insulating layer 205 is formed above second semiconductor layer 204 by depositing 270 nm SiₓN_{y} by plasma CVD.

By depositing first insulating layer 205, dielectric layer 206 including second semiconductor layer 204 and first insulating layer 205 is formed.

Then, as illustrated in FIG. 36, a mask for forming isolation region 221 is formed using photoresist 241. Then, as illustrated in FIG. 37, isolation region 221 is formed by removing respective portions of first insulating layer 205, second semiconductor layer 204, first semiconductor layer 203, and buffer layer 202 by dry etching using photoresist 241 as a mask.

Furthermore, instead of etching, isolation region 221 may be formed by implanting, by an ion implanter, molecules containing one of He, B, H, F, or Fe into respective portions of second semiconductor layer 204, first semiconductor layer 203, and buffer layer 202.

Then, as illustrated in FIG. 38, a portion of first insulating layer 205 is removed by drying etching using photoresist 242 as a mask, which forms the etched first step.

Then, as illustrated in FIG. 39, a portion of the etched first step on the side closer to second terminal 208 is protected, the etched first portion having been formed using photoresist 242. Photoresist 243 is formed to expose the same region as photoresist 242 except for the protected portion. A portion of first insulating layer 205 is removed by drying etching using photoresist 243 as a mask, which forms the etched second step.

Then, as illustrated in FIG. 40, a portion of the etched second step on the side closer to second terminal 208 is protected, the etched second step having been formed using photoresist 243. Photoresist 244 is formed to expose the same region as photoresist 243 expect for the protected portion. A portion of first insulating layer 205 is removed by drying etching using photoresist 244 as a mask, which forms the etched third step.

Then, as illustrated in FIG. 41, a portion of the etched third step on the side closer to second terminal 208 is protected, the etched third step having been formed using photoresist 244. Photoresist 245 is formed to expose the same region as photoresist 244 except for the protected portion. A portion of first insulating layer 205 is removed by drying etching using photoresist 245 as a mask, which forms the etched fourth step.

Then, as illustrated in FIG. 42, a portion of the etched fourth step on the side closer to second terminal 208 is protected, the etched fourth step having been formed using photoresist 245. Photoresist 246 is formed to expose the same region as photoresist 245 except for the protected portion. A portion of first insulating layer 205 is removed by drying etching using photoresist 246 as a mask, which forms the etched fifth step. As such, as illustrated in FIG. 42, first insulating layer 205 has a six-stepwise discontinuous change in its film thickness.

Then, as illustrated in FIG. 43, TiN and Al are sequentially deposited as third metal layer 303 by sputtering, and a mask for forming first electrode 207 is formed using photoresist 247.

Then, as illustrated in FIG. 44, first electrode 207 is formed above stepwise dielectric layer 206 by removing TiN and Al by dry etching using photoresist 247 as a mask. That is, third metal layer 303 that remains after the drying etching serves as first electrode 207.

It should be noted that the method of forming first electrode 207 may be a formation method in which an electrode material is evaporated onto a photoresist having an opening for only the pattern of first electrode 207 and then the photoresist, together with the electrode material adhering to the non-open portion of the resist, is stripped off with an organic chemical liquid or adhesive tape.

Then, as illustrated in FIG. 45, first protective insulating film 209 is deposited, and a mask for forming an opening for providing second terminal 208 is formed using photoresist 248. Respective portions of first protective insulating film 209, first insulating layer 205, second semiconductor layer 204, and first semiconductor layer 203 are removed by drying etching using photoresist 248 as a mask.

Then, as illustrated in FIG. 46, Ti and Al are sequentially deposited as fourth metal layer 304 by sputtering, and a mask for forming second terminal 208 is formed using photoresist 249.

Then, as illustrated in FIG. 47, Ti and Al are removed by dry etching using photoresist 249 as a mask. Moreover, after photoresist 249 is removed, Ti and Al deposited through the thermal process are alloyed, which forms second terminal 208 that can make ohmic contact with two-dimensional electron gas layer 220. Moreover, second protective insulating film 210 is deposited, and an opening pattern for exposing first electrode 207 and second terminal 208 is formed using photoresist 250.

It should be noted that the method of forming second terminal 208 may be a formation method in which in a region to form second terminal 208, an electrode material is evaporated onto a resist having an opening for the pattern of second terminal 208 and, then the resist, together with the electrode material adhering to the non-open portion of the resist, is stripped off with an organic chemical liquid. Furthermore, as long as second terminal 208 can make ohmic contact with two-dimensional electron gas layer 220, respective portions of second semiconductor layer 204 and first semiconductor layer 203 need not be removed. For instance, an ohmic junction may be formed by adding and implanting n-type impurities typified by Si into the semiconductor layers below second terminal 208 (that is, first semiconductor layer 203 and second semiconductor layer 204). Furthermore, the metal of second terminal 208 may be diffused close to two-dimensional electron gas layer 220 by a thermal process.

Then, as illustrated in FIG. 48, first protective insulating film 209 and second protective insulating film 210 are removed by dry etching using photoresist 250 as a mask, and then photoresist 250 is removed. In this way, variable capacitance element 200 according to Embodiment 2 in the present disclosure is manufactured.

As describe above, in Embodiment 2, the interval between the bottom surface of first electrode 207 and the top surface of first semiconductor layer 203 monotonically increases in the first direction, and the degree of increase indicating the degree of monotonic increase in the interval is not constant. More specifically, in Embodiment 2, a monotonic increase in distance 234 between the bottom surface of first electrode 207 and the bottom surface of second semiconductor layer 204 is a discontinuous stepwise increase. Thus, the area that depletion layer region 222 extends within two-dimensional electron gas layer 220 changes, and the area of second electrode 223 changes, depletion layer region 222 being generated by an electric field generated from the bottom surface of first electrode 207 according to the potential difference applied between first electrode 207 and second terminal 208. That is, variable capacitance element 200 is achieved in which the area of second electrode 223 discontinuously changes according to the magnitude of the potential difference between first electrode 207 and second terminal 208 and a capacitance value between first electrode 207 and second electrode 223 discontinuously changes.

Furthermore, FIG. 49 is a graph illustrating a change in the capacitance value with respect to the potential difference between first electrode 207 and second terminal 208 of variable capacitance element 200 according to Embodiment 2. For instance, as illustrated in FIG. 49, when the potential difference between first electrode 207 and second terminal 208 falls within the range from 0 to 40 V, the capacitance value indicates the following discontinuous change. For the potential differences greater than or equal to 0 V and less than 10 V, the capacitance value indicates 3.8 pF. For the potential differences greater than or equal to 10 V and less than 15 V, the capacitance value indicates around 2.6 pF. For the potential differences greater than or equal to 15 V and less than 20 V, the capacitance value indicates around 1.6 pF. For the potential differences greater than or equal to 20 V and less than 25 V, the capacitance value indicates around 1.1 pF. For the potential differences greater than or equal to 25 V and less than 30 V, the capacitance value indicates around 0.7 pF. For the potential differences greater than or equal to 30 V and less than 35 V, the capacitance value indicates around 0.4 pF. For the potential differences of at least 35 V and at most 40V, the capacitance value indicates around 0.1 pF. It should be noted that the graph in FIG. 49 showing the capacitance value with respect to the potential difference is based on simplified calculation in which only the capacitance component in the direction perpendicular to second electrode 223 (the z-axis direction) is taken into consideration, and there are some differences from the results of an actual operation.

In variable capacitance element 200 according to the present disclosure described above, distance 234 between the bottom surface of first electrode 207 and the bottom surface of second semiconductor layer 204 stepwisely monotonically increases in the direction from the side far from second terminal 208 to the side close to second terminal 208. This makes it possible to obtain a discontinuous change in the capacitance value according to the potential difference between first electrode 207 and second terminal 208, without using control by an additional terminal.

Furthermore, as described above, the stepwise monotonic increase in distance 234 between the bottom surface of first electrode 207 and the bottom surface of second semiconductor layer 204 from the side far from second terminal 208 to the side close to second terminal 208 enables calculation of a relationship between: the capacitance value between first electrode 207 and second electrode 223, and the potential difference applied between first electrode 207 and second electrode 223. Thus, quantitative calibration of the capacitance value is easier in comparison with the conventional technology.

Furthermore, in variable capacitance element 200 according to the present disclosure described above, the greater the height of a portion corresponding to each step of stepwise dielectric layer 206 is, a greater potential difference between first electrode 207 and second terminal 208 is necessary to change the area of second electrode 223. It should be noted that the height of the portion corresponding to each step is, for example, the distance (an elevation difference) in the z-axis direction between one of step surfaces and another step surface adjacent on the positive side of the x-axis. Accordingly, when the heights of the portions corresponding to the steps of stepwise dielectric layer 206 are high, even if an electric potential to control the capacitance value has a signal amplitude or is unstable, it is possible to control the change in the capacitance value to be within a predetermined range. As described in Embodiment 2, when the height of the portion corresponding to each step is at least 30 nm and at most 500 nm, the height of the portion corresponding to the step is high. Furthermore, the height of the portion corresponding to each step may be at least 80 nm and at most 400 nm and may be at least 150 nm and at most 300 nm. Specifically, as illustrated in FIG. 49, a potential difference of at least 5 V is necessary to change the capacitance value, as seen in the change in the capacitance value with respect to the voltage in stepwise dielectric layer 206 according to Embodiment 2. Thus, in variable capacitance element 200 according to Embodiment 2, even if the electric potential to control the capacitance value has a signal amplitude or is unstable, as long as the change is a change of at most 5 V, a significant change from the capacitance value set at a control voltage is not seen.

Here, with reference to FIG. 50, another example according to Embodiment 2 is described. FIG. 50 is a cross-sectional view illustrating a configuration of variable capacitance element 200 in another example according to Embodiment 2. As illustrated in FIG. 50, in variable capacitance element 200 in the example, dielectric layer 206 may include a first silicon nitride layer and a second silicon nitride layer provided above the first silicon nitride layer and having a composition ratio of Si to N lower than that of the first silicon nitride layer. More specifically, dielectric layer 206 includes the first silicon nitride layer, the second silicon nitride layer, a third silicon nitride layer, a fourth silicon nitride layer, a fifth silicon nitride layer, and a sixth silicon nitride layer. Furthermore, the composition ratio of Si to N becomes lower in the following order: the first silicon nitride layer, the second silicon nitride layer, a third silicon nitride layer, fourth silicon nitride layer, fifth silicon nitride layer, and sixth silicon nitride layer.

It should be noted that here, as illustrated in FIG. 50, first insulating layer 205 of dielectric layer 206 includes six layers each having a different composition and density of SiₓN_{y}. The six layers are stacked, and a stack of the six layers may have a total film thickness of 270 nm. When stacking the six SiₓN_{y} layers of first insulating layer 205, first insulating film 261 above and in direct contact with second semiconductor layer 204, second insulating film 262, third insulating film 263, fourth insulating film 264, fifth insulating film 265, and sixth insulating film 266 are sequentially stacked. It should be noted that first insulating film 261 corresponds to the first silicon nitride layer, second insulating film 262 corresponds to the second silicon nitride layer, third insulating film 263 corresponds to the third silicon nitride layer, fourth insulating film 264 corresponds to the fourth silicon nitride layer, fifth insulating film 265 corresponds to the fifth silicon nitride layer, and sixth insulating film 266 corresponds to the sixth silicon nitride layer. Regarding first insulating film 261 to sixth insulating film 266, the amount of etching by drying etching increases toward the top layer of first insulating layer 205. The amount of etching by drying etching can be controlled by composition x of Si and composition y of N in SiₓN_{y} and the density. For instance, the lower the composition ratio of Si to N is, the amount of etching increases. Furthermore, the film thicknesses of first insulating film 261 to sixth insulating film 266 of first insulating layer 205, which are illustrated in the cross-sectional view in FIG. 50, are as follows: first insulating film 261 is 11 nm thick, second insulating film 262 is 43 nm thick, third insulating film 263 is 43 nm thick, fourth insulating film 264 is 43 nm thick, fifth insulating film 265 is 43 nm thick, and sixth insulating film 266 is 43 nm thick.

It should be noted that the layer number of the insulating films of first insulating layer 205 is at least two.

In the above configuration, each of first insulating film 261 to sixth insulating film 266 serves as an etching stopper layer for the layer above the film, which can suppress variations in the heights in the steps and form the steps of first insulating layer 205 in a well-controlled manner.

Here, with reference to FIG. 51, another example according to Embodiment 2 is described.

FIG. 51 is a cross-sectional view illustrating a configuration of variable capacitance element 200 in another example according to Embodiment 2.

In variable capacitance element 200 in the example, the interval between the bottom surface of first electrode 207 and the top surface of first semiconductor layer 203 monotonically increases in the first direction, and the degree of increase indicating the degree of monotonic increase in the interval is not constant. Moreover, the degree of increase becomes smaller with an increase in the interval. For instance, as illustrated in FIG. 51, first width 251 to sixth width 256 obtained by dividing the width of first insulating layer 205 into six widths in accordance with the steps of first insulating layer 205 may not be constant. Furthermore, as illustrated in FIG. 51, here, the portions corresponding to the five steps have heights, and the heights of the portions corresponding to the five steps are the same. Thus, the relationship between: the capacitance value between first electrode 207 and second electrode 223, and the potential difference applied between first electrode 207 and second terminal 208 shows a relationship as illustrated in FIG. 52. FIG. 52 is a graph illustrating a change in the capacitance value with respect to the potential difference between first electrode 207 and second terminal 208 of variable capacitance element 200 in another example according to Embodiment 2. It should be noted that FIG. 52 is a graph relating to variable capacitance element 200 described with reference to FIG. 51. As illustrated in FIG. 52, in variable capacitance element 200 in the example, the capacitance value between first electrode 207 and second electrode 223 discontinuously changes, which further facilitates designing of a circuit. More specifically, for instance, when the applied voltage is greater than 10 V and less than 15 V, the amount of change in the capacitance value is constant (that is, the inclination is constant), which further facilitates designing of a circuit. Furthermore, the degree of increase indicating the degree of monotonic increase in the interval is not constant, and the degree of increase becomes smaller with an increase in the interval (toward the positive side of the x-axis). For instance, when first width 251 is 0.20 µm, second width 252 is 0.30 µm, third width 253 is 0.40 µm, fourth width 254 is 0.6 µm, fifth width 255 is 0.7 µm, and sixth width 256 is 0.8 µm, the relationship illustrated in FIG. 52 is obtained. It should be noted that the graph in FIG. 52 showing the capacitance value with respect to the potential difference is based on simplified calculation in which only the capacitance component in the direction perpendicular to second electrode 223 (the z-axis direction) is taken into consideration, and there are some differences from the results of an actual operation.

Here, with reference to FIG. 53, another example according to Embodiment 2 is described.

FIG. 53 is a cross-sectional view illustrating a configuration of variable capacitance element 200 in another example according to Embodiment 2. (a) in FIG. 53 is a plan view illustrating a configuration of variable capacitance element 200 in another example according to Embodiment 2, and (b) in FIG. 53 is a cross-sectional view of variable capacitance element 200 at the position corresponding to line (b)-(b) in (a) in FIG. 53.

As illustrated in (a) the plan view and (b) the cross-sectional view in FIG. 53, in variable capacitance element 200 in the example, first electrode 207 has two stepwise portions. In (b) in FIG. 53, the two stepwise portions are shown inside the two rectangular areas (area A and area B) indicated by the long-dashed double-short dashed lines. That is, first electrode 207 in first insulating layer 205 has two stepwise portions, one on the side close to second terminal 208 and the other on the side far from second terminal 208. In this case, the stepwise portion of first insulating layer 205 on the side far from second terminal 208 does not affect the operation of variable capacitance element 200 described above.

Moreover, with reference to FIG. 54, a variation of Embodiment 2 is described (not part of the claimed invention). FIG. 54 includes a plan view and a cross-sectional view that illustrate a configuration of variable capacitance element 200a according to the variation of Embodiment 2. (a) in FIG. 54 is a plan view illustrating a configuration of variable capacitance element 200a according to the variation of Embodiment 2, and (b) in FIG. 54 is a cross-sectional view of variable capacitance element 200a at the position corresponding to line (b)-(b) in (a) in FIG. 54.

Variable capacitance element 200a according to the variation includes first capacitor 200b, second capacitor 200c, third capacitor 200d, first line layer 270, and second line layer 270a.

First capacitor 200b to third capacitor 200d each have the same configuration as variable capacitance element 200 described with reference to FIG. 32 except for the following point. Specifically, as the different point, first electrode 207 of each of first capacitor 200b to third capacitor 200d does not have steps.

It should be noted that first electrode 207 and second electrode 223 of one capacitor may be referred to as a pair of first electrode 207 and second electrode 223.

First capacitor 200b to third capacitor 200d are, for instance, aligned in the first direction that is the direction (the positive direction of the x-axis) from first electrode 207 of first capacitor 200b toward second terminal 208 of first capacitor 200b. However, the arrangement of the capacitors is not limited to the above arrangement. For instance, first capacitor 200b to third capacitor 200d may be, for instance, aligned in the second direction (the y-axis direction) orthogonal to the first direction in plan view of substrate 201.

Furthermore, in the variation, first capacitor 200b to third capacitor 200d share one substrate 201. Likewise, first capacitor 200b to third capacitor 200d share one buffer layer 202. It should be noted that in each of first capacitor 200b to third capacitor 200d, the thickness of second semiconductor layer 204 is constant.

Here, the interval between the bottom surface of first electrode 207 of first capacitor 200b and the top surface of first semiconductor layer 203 of first capacitor 200b is defined as a first interval. Furthermore, the interval between the bottom surface of first electrode 207 of second capacitor 200c and the top surface of first semiconductor layer 203 of second capacitor 200c is defined as a second interval. Moreover, the interval between the bottom surface of first electrode 207 of third capacitor 200d and the top surface of first semiconductor layer 203 of third capacitor 200d is defined as a third interval. Here, moreover, as illustrated in FIG. 54, the film thicknesses of first insulating layer 205 in first capacitor 200b to third capacitor 200d are defined as film thickness 231b, film thickness 231c, and film thickness 231d, respectively. In the variation, the first interval is shorter than the second interval, and the second interval is shorter than the third interval. That is, film thickness 231b is less than film thickness 231c, and film thickness 231c is less than film thickness 231d. That is, in the variation, steps are formed by differences in the film thicknesses of first insulating layers 205.

Furthermore, in the variation, first line layer 270 and second line layer 270a contain conductive materials. First line layer 270 electrically connects first electrode 207 of first capacitor 200b, first electrode 207 of second capacitor 200c, and first electrode 207 of third capacitor 200d. Second line layer 270a electrically connects second terminal 208 of first capacitor 200b, second terminal 208 of second capacitor 200c, second terminal 208 of third capacitor 200d.

As described above, as illustrated in (a) the plan view in FIG. 54 and (b) the cross-sectional view in FIG. 54, the steps formed by first insulating layer 205 are provided. Moreover, not only a pair of first electrode 207 and second electrode 223 are provided but also pairs of first electrode 207 and second electrode 223 are provided. In this case, by connecting first electrodes 207 to each other using first line layer 270, and connecting second electrodes 223 to each other (second terminals 208 to each other) using second line layer 270a, as the composite capacitors of first insulating layers 205 having different film thicknesses, it is possible to obtain the same effects as those of the steps of the stepwise portion in a pair of first electrode 207 and second electrode 223 illustrated in FIGS. 33 and 34, for example. That is, as described in the variation, the first interval is shorter than the second terminal, and the second terminal is shorter than the third interval, which achieves variable capacitance element 200a in which the capacitance value between first line layer 270 and second line layer 270a changes according to the voltage applied between first line layer 270 and second line layer 270a.

In the above embodiments, various changes, replacement, addition, and omission can be performed within the scope of the claims.

### [Industrial Applicability]

Because of their high-speed operation capability and high controllability of capacitance, the variable capacitance elements according to the present disclosure are useful for the matching circuit of a mobile communication device that requires high-speed operation.

### [Reference Signs List]

100, 200, 200a variable capacitance element
101, 201 substrate
102, 202 buffer layer
103, 203 first semiconductor layer
104, 204 second semiconductor layer
105, 205 first insulating layer
106, 206 dielectric layer
107, 207 first electrode
108, 208 second terminal
109, 209 first protective insulating film
110, 210 second protective insulating film
111 second insulating layer
112 field plate electrode
120, 220 two-dimensional electron gas layer
121, 221 isolation region
122, 222 depletion layer region
123, 223 second electrode
124, 224 width
125, 225 length
126, 226 width
127, 227 length
130 inclination angle θ
131, 132, 231, 231b, 231c, 231d, 232 film thickness
133 inclination angle Φ
134, 234 distance
141, 241 photoresist
142, 242 photoresist
143, 243 photoresist
144, 244 photoresist
145, 245 photoresist
146, 246 photoresist
147, 247 photoresist
200b first capacitor
200c second capacitor
200d third capacitor
248 photoresist
249 photoresist
250 photoresist
251 first width
252 second width
253 third width
254 fourth width
255 fifth width
256 sixth width
261 first insulating film
262 second insulating film
263 third insulating film
264 fourth insulating film
265 fifth insulating film
266 sixth insulating film
270 first line layer
270a second line layer
301 first metal layer
302 second metal layer
303 third metal layer
304 fourth metal layer

## Claims

1. A variable capacitance element comprising:
a substrate (101);
a first semiconductor layer (103) provided above the substrate;
a dielectric layer (106) provided above the first semiconductor layer and including a second semiconductor layer (104) having a band gap larger than a band gap of the first semiconductor layer;
a two-dimensional electron gas layer (120) provided at an interface between the first semiconductor layer and the second semiconductor layer;
a first electrode (107) provided above the dielectric layer and including a first terminal; and
a second terminal (108) spaced apart from the first electrode in a plan view of the substrate and electrically connected to the two-dimensional electron gas layer,
wherein the two-dimensional electron gas layer below the first electrode functions as a second electrode,
an interval between a bottom surface of the first electrode and a top surface of the first semiconductor layer monotonically increases in a first direction or in a second direction, the first direction being a direction (x) from the first electrode toward the second terminal, the second direction (y) being orthogonal to the first direction in the plan view of the substrate, and
a capacitance value between the first electrode and the second electrode changes according to a voltage applied between the first electrode and the second terminal.

2. The variable capacitance element according to claim 1,
wherein the dielectric layer includes an insulating layer, and a thickness of the insulating layer monotonically increases in the first direction or in the second direction.

3. The variable capacitance element according to claim 2,
wherein the insulating layer includes a first insulating layer and a second insulating layer that has an insulation withstand voltage higher than an insulation withstand voltage of the first insulating layer.

4. The variable capacitance element according to any one of claims 1 to 3,
wherein a thickness of the second semiconductor layer monotonically increases in the first direction or in the second direction.

5. The variable capacitance element according to any one of claims 1 to 4,
wherein when the substrate is viewed in cross section,
an elevation angle that the bottom surface of the first electrode forms with the top surface of the first semiconductor layer is at least 5 degrees and at most 60 degrees.

6. The variable capacitance element according to any one of claims 1 to 5,
wherein a degree of increase indicating a degree of monotonic increase in the interval is not constant.

7. The variable capacitance element according to any one of claims 1 to 6,
wherein the dielectric layer includes:
a first silicon nitride layer; and
a second silicon nitride layer provided above the first silicon nitride layer and having a composition ratio of Si to N lower than a composition ratio of Si to N of the first nitride silicon layer.

8. The variable capacitance element according to any one of claims 1 to 7,
wherein a degree of increase indicating a degree of monotonic increase in the interval is not constant, and
the degree of increase becomes smaller with an increase in the interval between the bottom surface of the first electrode and the top surface of the first semiconductor layer.

9. The variable capacitance element according to any one of claims 1 to 8, further comprising:
a field plate electrode provided between the first electrode and the second terminal and set to a ground potential.

10. The variable capacitance element according to any one of claims 1 to 8, further comprising:
a field plate electrode provided between the first electrode and the second terminal and set to an electric potential of the first electrode.

## Patentansprüche

1. Element mit variabler Kapazität, umfassend:
ein Substrat (101);
eine erste Halbleiterschicht (103), die über dem Substrat bereitgestellt ist;
eine dielektrische Schicht (106), die über der ersten Halbleiterschicht bereitgestellt ist und eine zweite Halbleiterschicht (104) umfasst, die eine Bandlücke aufweist, die größer als eine Bandlücke der ersten Halbleiterschicht ist;
eine zweidimensionale Elektronengasschicht (120), die an einer Grenzfläche zwischen der ersten Halbleiterschicht und der zweiten Halbleiterschicht bereitgestellt ist;
eine erste Elektrode (107), die über der dielektrischen Schicht bereitgestellt ist und einen ersten Anschluss umfasst; und
einen zweiten Anschluss (108), der von der ersten Elektrode in einer Draufsicht des Substrats beabstandet ist und elektrisch mit der zweidimensionalen Elektronengasschicht verbunden ist;
wobei die zweidimensionale Elektronengasschicht unter der ersten Elektrode als eine zweite Elektrode wirkt,
ein Intervall zwischen einer unteren Oberfläche der ersten Elektrode und einer oberen Oberfläche der ersten Halbleiterschicht monoton in einer ersten Richtung oder in einer zweiten Richtung zunimmt, wobei die erste Richtung eine Richtung (x) von der ersten Elektrode hin zu dem zweiten Anschluss ist, wobei die zweite Richtung (y) in der Draufsicht des Substrats orthogonal zur ersten Richtung ist, und
ein Kapazitätswert zwischen der ersten Elektrode und der zweiten Elektrode sich gemäß einer Spannung ändert, die zwischen der ersten Elektrode und dem zweiten Anschluss angelegt wird.

2. Element mit variabler Kapazität nach Anspruch 1,
wobei die dielektrische Schicht eine isolierende Schicht umfasst und eine Dicke der isolierenden Schicht monoton in der ersten Richtung oder in der zweiten Richtung zunimmt.

3. Element mit variabler Kapazität nach Anspruch 2,
wobei die isolierende Schicht eine erste isolierende Schicht und eine zweite isolierende Schicht umfasst, die eine Isolationsstehspannung aufweist, die höher als eine Isolationsstehspannung der ersten isolierenden Schicht ist.

4. Element mit variabler Kapazität nach einem der Ansprüche 1 bis 3,
wobei eine Dicke der zweiten Halbleiterschicht monoton in der ersten Richtung oder in der zweiten Richtung zunimmt.

5. Element mit variabler Kapazität nach einem der Ansprüche 1 bis 4,
wobei, wenn das Substrat im Querschnitt betrachtet wird,
ein Höhenwinkel, den die untere Oberfläche der ersten Elektrode mit der oberen Oberfläche der ersten Halbleiterschicht bildet, mindestens 5 Grad und höchstens 60 Grad beträgt.

6. Element mit variabler Kapazität nach einem der Ansprüche 1 bis 5,
wobei ein Grad einer Zunahme, die einen Grad einer monotonen Zunahme in dem Intervall angibt, nicht konstant ist.

7. Element mit variabler Kapazität nach einem der Ansprüche 1 bis 6,
wobei die dielektrische Schicht umfasst:
eine erste Siliziumnitridschicht; und
eine zweite Siliziumnitridschicht, die über der ersten Siliziumnitridschicht bereitgestellt ist und ein Zusammensetzungsverhältnis von Si zu N aufweist, das niedriger als ein Zusammensetzungsverhältnis von Si zu N der ersten Siliziumnitridschicht ist.

8. Element mit variabler Kapazität nach einem der Ansprüche 1 bis 7,
wobei ein Grad einer Zunahme, der einen Grad einer monotonen Zunahme in dem Intervall angibt, nicht konstant ist, und
der Grad der Zunahme mit einer Zunahme beim Intervall zwischen der unteren Oberfläche der ersten Elektrode und der oberen Oberfläche der ersten Halbleiterschicht kleiner wird.

9. Element mit variabler Kapazität nach einem der Ansprüche 1 bis 8, ferner umfassend:
eine Feldplattenelektrode, die zwischen der ersten Elektrode und dem zweiten Anschluss bereitgestellt ist und auf ein Erdpotential eingestellt ist.

10. Element mit variabler Kapazität nach einem der Ansprüche 1 bis 8, ferner umfassend:
eine Feldplattenelektrode, die zwischen der ersten Elektrode und dem zweiten Anschluss bereitgestellt ist und auf ein elektrisches Potential der ersten Elektrode eingestellt ist.

## Revendications

1. Élément à capacité variable, comprenant :
un substrat (101) ;
une première couche de semi-conducteur (103) placée au-dessus du substrat ;
une couche diélectrique (106) placée au-dessus de la première couche de semi-conducteur et comprenant une deuxième couche de semi-conducteur (104) ayant une bande interdite plus large qu'une bande interdite de la première couche de semi-conducteur ;
et une couche de gaz bidimensionnel d'électrons (120) placée au niveau d'une interface entre la première couche de semi-conducteur et la deuxième couche de semi-conducteur ;
une première électrode (107) placée au-dessus de la couche diélectrique et comprenant une première borne ; et
une deuxième borne (108) espacée de la première électrode dans une vue en plan du substrat et connectée électriquement à la couche de gaz bidimensionnel d'électrons,
dans lequel la couche de gaz bidimensionnel d'électrons en dessous de la première électrode fonctionne comme une deuxième électrode,
un intervalle entre une surface inférieure de la première électrode et une surface supérieure de la première couche de semi-conducteur augmente de façon monotone dans une première direction ou une deuxième direction, la première direction étant une direction (x) allant de la première électrode vers la deuxième borne, la deuxième direction (y) étant orthogonale à la première direction dans la vue en plan du substrat, et
une valeur de capacité entre la première électrode et la deuxième électrode varie en fonction d'une tension appliquée entre la première électrode et la deuxième borne.

2. Élément à capacité variable selon la revendication 1,
dans lequel la couche diélectrique comprend une couche isolante, et une épaisseur de la couche isolante augmente de façon monotone dans la première direction ou dans la deuxième direction.

3. Élément à capacité variable selon la revendication 2,
dans lequel la couche isolante comprend une première couche isolante et une deuxième couche isolante qui a une tension de résistance d'isolement supérieure à une tension de résistance d'isolement de la première couche isolante.

4. Élément à capacité variable selon l'une quelconque des revendications 1 à 3,
dans lequel une épaisseur de la deuxième couche de semi-conducteur augmente de façon monotone dans la première direction ou dans la deuxième direction.

5. Élément à capacité variable selon l'une quelconque des revendications 1 à 4,
dans lequel, lorsque le substrat est vu en coupe transversale,
un angle d'élévation que forme la surface inférieure de la première électrode avec la surface supérieure de la première couche de semi-conducteur est au moins de 5 degrés et d'au plus de 60 degrés.

6. Élément à capacité variable selon l'une quelconque des revendications 1 à 5,
dans lequel un degré de hausse indiquant un degré d'augmentation monotone dans l'intervalle n'est pas constant.

7. Élément à capacité variable selon l'une quelconque des revendications 1 à 6,
dans lequel la couche diélectrique comprend :
une première couche de nitrure de silicium ; et
une deuxième couche de nitrure de silicium placée au-dessus de la première couche de nitrure de silicium et ayant un rapport de composition du Si sur le N inférieur à un rapport de composition du Si sur le N de la première couche de nitrure de silicium.

8. Élément à capacité variable selon l'une quelconque des revendications 1 à 7,
dans lequel un degré de hausse indiquant un degré d'augmentation monotone dans l'intervalle n'est pas constant, et
le degré de hausse devient inférieur à une hausse dans l'intervalle entre la surface inférieure de la première électrode et la surface supérieure de la première couche de semi-conducteur.

9. Élément à capacité variable selon l'une quelconque des revendications 1 à 8, comprenant en outre :
une électrode plate de champ placée entre la première électrode et la deuxième borne et mise à un potentiel de terre.

10. Élément à capacité variable selon l'une quelconque des revendications 1 à 8, comprenant en outre :
une électrode plate de champ placée entre la première électrode et la deuxième borne et mise à un potentiel électrique de la première électrode.
